# EUROPEAN PATENT SPECIFICATION

(11) **EP 2 319 104 B1**
(45) Date of publication and mention of the grant of the patent: **24.06.2015**
(21) Application number: 09785435.0
(22) Date of filing: 31.07.2009
(51) Int. Cl.: H01L 51/00

(54) **FORMING ELECTRICALLY INSULATIVE REGIONS**
BILDUNG VON ELEKTRISCH ISOLIERENDEN REGIONEN
FORMATION DE REGIONS ELECTRIQUEMENT ISOLANTES

(30) Priority: 31.07.2008 GB 0814028; 28.01.2009 GB 0901389
(43) Date of publication of application: 11.05.2011
(73) Proprietor: Pragmatic Printing Ltd, Manchester M40 5WW (GB)
(72) Inventor: SONG, Aimin, Greater Manchester SK4 2BG (GB); WHITELEGG, Stephen, Greater Manchester SK6 2PR (GB); SUN, Yanming, Shandong 262119 (CN)
(74) Representative: Jenkins, Richard Gavin
(86) International application number: PCT/GB2009/050963
(87) International publication number: WO 2010/013067

(56) References cited:
- EP-A- 1 919 006
- WO-A-02/29912
- WO-A-02/086973
- WO-A-2006/120414
- WO-A-2007/074404
- GB-A- 2 427 509

## Description

### Field of the Invention

The present invention relates to the formation of electrically insulative regions in layers of electrically conductive or semiconductive material, and in particular, although not exclusively, to the formation of such insulative regions to define electrical and/or electronic devices in the active layer and/or to isolate a device or devices in one region of the layer from a device or devices in another region.

### Background to the Invention

Electrical and/or electronic devices comprising one or more layers of active (that is electrically conductive or semiconductive) material are well known. These known devices include devices in which an active layer has been patterned with an array of insulative features (in other words, an array of insulative features has been formed in the layer), that array or pattern defining electrical and/or electronic properties of the resultant device. Thus, it is known to form insulative features in active layers to define a variety of devices. Examples are disclosed in WO 02/086973 A2, WO 2006/008467 A1, and WO 2006/120414 A2. EP1919006A and WO2007/074404A also disclose the patterning of layers of active material to produce electronic devices.

In addition to forming insulative features in active layers to define devices, it is also known to form insulative features in those layers in order to electrically isolate one region of the layer (which may, for example comprise a number of devices forming a circuit or part of a circuit) from another region of the layer.

Known techniques for producing insulative features in active layers of conductive or semiconductive material include etching and embossing.

When the required insulative features generally take the form of narrow lines, appropriate etching or embossing techniques may be used with relatively little difficulty. For example, to etch away a narrow line of active material to produce a narrow, linear insulative feature one does not have to remove much material from the layer. The etching process may therefore be relatively quick to perform. In order to produce a narrow insulative line using an embossing technique, one can use an embossing tool provided with a corresponding narrow embossing feature, raised above a base surface.

Problems occur, however, when relatively large insulative features are required, that is when the insulative features are to be insulative regions occupying, covering, spanning or otherwise extending over an area of the layer of active material. Such insulative regions could be in the form of relatively thick lines, or substantial interruptions in the layer of active material. Such insulative regions may be required instead of thin insulative lines in applications where the insulative line would pose an insufficient barrier to electrical conduction across itself.

Clearly, one way of forming a large insulative region over an area of an active layer would be to etch or otherwise remove all of the active material from that area (producing, in effect, a large void). However, a disadvantage with this approach is that processing times are increased as the amount of material to be removed is itself large, as compared with the removal of narrow lines of material. The latter is particularly problematic for the field of printed and/or large-area electronics which has the aim to produce electronics "on-demand" at high-throughput comparable with conventional printing speeds rather than silicon fabrication throughput.

Another possible way of trying to produce a relatively large or wide insulative feature by embossing would be to use a correspondingly large embossing feature to displace the entire area of active material out of the layer. However, a disadvantage with this approach is that by increasing the size of the embossing feature, for a given embossing force, the pressure exerted on the active material is reduced. Therefore, a previously adequate force may be insufficient to exert enough pressure to displace the area of active material. One could try to increase the embossing force, but this can also pose practical difficulties such as stamp bending or failure and material fracture. Furthermore, even if sufficient force were available, there remains the problem of where the displaced material goes. In general it is very difficult to displace large areas of active material using an embossing technique and yet achieve good electrical isolation between the displaced material and undisplaced material in the layer.

### Summary of the Invention

It is an aim of certain embodiments of the invention to solve, mitigate, or obviate, at least partly, at least one of the problems and/or disadvantages associated with the prior art. According to a first aspect of the present invention there is provided a method of forming an electrically insulative region from an area of a layer of electrically active (i.e. electrically conductive or semiconductive) material, such that electrical current flow within the layer and across said area is at least inhibited, the method being as defined by claim 1, and including:
forming at least one electrically insulative feature in said layer to define an insulative perimeter around said area, the or each insulative feature being arranged to at least inhibit electrical current flow within the layer of material; and
forming at least one further electrically insulative feature inside said perimeter so as to divide said area into a plurality of parts, said parts being at least partially electrically insulated (isolated) from each another.

In other words, the forming of the at least one further electrically insulative feature inside the perimeter so as to divide the area into a plurality of parts is such that electrical current flow within the layer and from one of said parts to another of said parts is at least inhibited.

Thus, an insulative region having substantially said area is formed without having to remove all of the active material in said area and without having to displace all of the active material of said area out of the layer. Instead, the insulative region spanning the area is formed by a technique including forming an insulative perimeter around the area. Additionally, and to further improve the insulative properties of the region, the area inside the perimeter is further sub-divided by at least one additional insulative feature. The insulative perimeter at least inhibits electrical current flow from active material outside the perimeter to insulative material inside the perimeter. The further insulative feature or features at least inhibit current flow within the perimeter.

In certain embodiments, the insulative perimeter may be defined by just a single insulative feature, such as an insulative recess, channel, groove or trench in a ring. In alternative embodiments, the insulative perimeter may be defined by a plurality of insulative features formed in the active layer, such as a number of intersecting, crossing, or meeting lines. Thus, said forming of at least one electrically insulative feature may comprise forming a plurality of said insulative features to define said perimeter.

According to this first aspect, said forming of at least one further electrically insulative feature comprises forming a plurality of further electrically insulative features inside said perimeter so as to divide the area into said plurality of parts, and said plurality of further electrically insulative features comprises a plurality of substantially linear further insulative features arranged as a grid.

Generally, the greater the number of further electrically insulative features used, the greater the subdivision of the area of active material inside the perimeter.

It will be appreciated that the plurality of parts into which the area is divided by the further electrically insulative feature or features can be described as islands of active material, each island being surrounded or bounded by an insulative feature or features (i.e. surrounded itself by an insulative perimeter inside the overall perimeter of the area).

The greater the subdivision of the area, the better its insulative properties, i.e. the better its performance as a barrier to current flow across itself.

It will be appreciated that an advantage provided by embodiments of the invention is that although the overall area of the insulative region may be relatively large, the individual electrically insulative and further insulative features may themselves be relatively fine or narrow. This is advantageous as it means that embossing techniques can be used to form the insulative features and therefore the insulative region. As the individual insulative features are narrow, correspondingly narrow embossing features can be used on an embossing tool, so enabling relatively high embossing pressures to be applied with relatively small embossing forces. Another way of looking at this is that relatively fine embossing features can be used to form embodiments of the invention, and these embossing features can, in certain cases, penetrate the active layer relatively easily to form the insulative features.

In certain embodiments, said plurality of further electrically insulative features comprises a plurality of substantially linear further insulative features arranged in parallel (with each other)(i.e. the plurality comprises a parallel array of at least two linear insulative features).

These parallel insulative features inside the overall perimeter can thus divide the area of active material, or at least a portion of it, into a plurality of strips. Although electrical conduction along each strip is possible, conduction from one strip to the adjacent one is at least inhibited. According to this first aspect, the grid, of crossing, intersecting, or meeting lines (insulative features) divides at least a portion of the area into a plurality of islands of conductive or semiconductive material, the islands being at least partially electrically isolated from each other.

Furthermore, the grid arrangement provides an advantage over just using parallel, non-crossing features, in that it further subdivides the area within the perimeter, improving the electrical isolation ability of the insulative region as a whole.

In certain embodiments the grid may be a rectangular grid, although other forms of grid may be used in alternative embodiments (that is, the lines may not cross, intersect, or meet each other at 90°).

In certain embodiments, arrays of crossing and/or intersecting insulative features having forms other than grids may be used to subdivide the area within the perimeter. In certain embodiments, at least one of the insulative features inside the perimeter may extend through, and beyond the perimeter.

In certain embodiments, the electrically insulative region is itself substantially linear. Thus, the region may be formed so as to provide a relatively thick insulating line to define at least part of an electrical and/or electronic device, or for use to simply isolate one region of the active layer from another region.

In certain embodiments, the electrically insulative region is arranged to surround a portion of the layer of electrically conductive or semiconductive material, to electrically isolate, at least partly, that portion from a portion outside the electrically insulative region.

In certain embodiments, the insulative and further insulative features may comprise insulative features having a plurality of forms and/or shapes. However, in certain embodiments each insulative and further insulative feature is substantially linear.

In certain embodiments, at least one of the insulative and further insulative features comprises a respective trench, groove, or channel formed in the active layer so as to interrupt the active layer. In certain embodiments, the trench, groove, or channel may extend just partially into the active layer, but in alternative embodiments each trench, groove or channel extends through (i.e. completely through) the active layer so as to fully interrupt it and provide a barrier to current flow within the layer across the trench, groove, or channel.

In certain embodiments, the method comprises forming each of the insulative and further insulative features at the same time, i.e. in parallel. This can be achieved, for example, by forming all of these insulative features by embossing the active layer with an embossing tool having a flat base surface, and a plurality of embossing features raised above that surface. Alternatively, a mask could be used and then each insulative feature could be formed by etching unmasked portions of the active layer at the same time.

In alternative embodiments, the insulative and further insulative features are not necessarily formed at the same time as one another.

In certain embodiments, the method may comprise displacing active material at least partially from the active layer to form at least one of said insulative and further insulative features. This can be achieved, for example, using an embossing tool.

In certain embodiments the embossing tool may be moved around with respect to the active layer so as to create the various insulative features in sequence.

Alternatively, the embossing tool may comprise a plurality of embossing features raised above a base surface, each embossing feature corresponding to a respective one of the insulative and further insulative features. Thus, the embossing tool may be provided with a pattern which corresponds to all of the insulative features to be formed in the layer to produce the insulative region with its sub-divided interior.

In certain embodiments, said layer is supported by a layer of compressible material, and using the embossing tool comprises urging the embossing tool towards the compressible material so as to displace a plurality of selected portions of the layer of conductive or semiconductive material towards the compressible material so as to compress compressible material under each displaced portion, wherein each displaced portion corresponds to a respective one of the insulative and further insulative features.

In certain embodiments, the method comprises removing active material from the active layer to form at least one of the insulative and further insulative features. This removing may comprise at least one of: machining (including micro or nano machining); etching; and laser ablation.

In certain embodiments, the various insulative features may be formed using known lithography techniques.

In certain embodiments, the method comprises depositing a layer of protective resist material on top of the active layer, patterning the resist material to expose certain areas of the active layer and removing the active material from the unprotected areas. Such resist material may include photoresist, microresist or thermoplastic. Such patterning may include laser ablation, embossing, nanoimprint or photolithography. The removal of active material may include etching (e.g. wet, dry, reactive-ion, etc.), ion milling or plasma.

In certain embodiments, the area of active material has a minor dimension D, and each insulative and/or further insulative feature has a width no greater than D/3, D/4, D/5, or even smaller. Thus, the relatively large insulative region may be defined by a plurality of relatively narrow features.

Another aspect of the invention provides a layer of electrically active material interrupted by an electrically insulative region occupying an area of said layer, the electrically insulative region comprising:
at least one electrically insulative feature arranged to interrupt said layer to define an insulative perimeter around said area; and
a plurality of further electrically insulative features arranged inside said perimeter and interrupting said layer so as to divide said area into a plurality of parts, said parts being at least partially electrically insulated from each other, wherein said plurality of further electrically insulative features comprises a plurality of substantially linear further insulative features arranged as a grid.

Another aspect provides an electrical or electronic device comprising a layer of electrically active material in accordance with the above-mentioned aspect.

Another aspect of the invention provides an electrical or electronic device comprising a layer of electrically active material and at least one electrically insulative region formed from a respective area of said layer using a method in accordance with any claim of this specification.

Another aspect provides a method of manufacturing an electrical or electronic device comprising a layer of electrically active material, the method comprising using a method in accordance with any claim of this specification to form at least one electrically insulative region in said layer.

Methods embodying the present invention may employ techniques as described in UK patent applications GB0814028.7 and GB0901389.7 to form insulative features (to form insulative regions and other features in an active layer). Additionally, the present application claims priority from those two GB applications. Certain embodiments of the invention comprise insulative features and/or patterned layers of active material formed using techniques disclosed in GB0814028.7 and GB0901389.7.

In certain embodiments, forming the insulative, further insulative, and, optionally, additional insulative features comprises:
providing a layer of compressible material supporting the layer of active material; and
forming each of said features by a method comprising displacing a respective selected portion of the layer of active material towards the compressible material so as to compress compressible material under the or each displaced portion and separate at least partly the or each displaced portion from undisplaced active material.

For the purposes of the present specification, the term "insulative" is to be understood as encompassing both completely insulative (i.e. completely electrically isolating) features as well as "relatively insulative", that is having a conductivity less than, or substantially less than, that of the uninterrupted active material. In other words, each insulative feature provides at least a partial barrier to current flow in the layer of active material across the feature.

In certain embodiments, said displacing comprises separating the or each displaced portion from undisplaced active material.

In certain embodiments, the layer of active material has a thickness T and said displacing comprises displacing the or each selected portion towards the compressible material by a distance greater than T. In certain embodiments, the layer of active material has a thickness T and said displacing comprises displacing the or each selected portion towards the compressible material by a distance less than or equal to T.

In certain embodiments, the compressible material is at least partially resilient, the method further comprising allowing the or each displaced portion to return at least partially towards the layer of active material.

In certain embodiments, the said displacing comprises producing an inelastic (i.e. permanent, irreversible, plastic etc) deformation of compressible material under the or each displaced portion, so as to leave the or each displaced portion permanently offset from the layer of active material.

In other words, the displacing of selected portions and the compression of compressible material may produce deformations of the compressible material having at least an inelastic component, such that when the force or action causing the displacement is removed, the compressible material does not return fully, or in certain cases does not return at all, to its original position, leaving the displaced portion of active material permanently offset from the active layer.

In certain embodiments, said inelastic deformation is such that the or each displaced portion is permanently displaced by a distance greater than T.

In certain embodiments, the displacement of the or each selected portion forms a permanent depression or trench in the layer of active material.

In some embodiments, the displacing operation may be such that substantially no active material lines the side walls of the depression or trench, such that the displaced portion of active material is electrically isolated or disconnected from portions of the active layer on either side of the trench. However, in alternative embodiments there may be some active material on the side walls of the depressions or trenches, and the method may comprise a step to remove such material in order to more fully electrically isolate the displaced portion from the undisplaced layer.

In certain embodiments, the method further comprises removing active material from side walls of the or each depression or trench.

In certain embodiments, the method further comprises filling the or each depression or trench with insulative material.

In certain embodiments, said displacing comprises severing the or each selected portion of active material from the layer of active material.

In certain embodiments, said compressible material is porous and said displacing comprises compressing the compressible material to reduce a porosity of the compressible material under the or each displaced portion.

In certain embodiments, said displacing comprises compressing compressible material from a first density to a second, higher density.

In certain embodiments, said compressible material is an insulative material, for example an insulative material selected from a list comprising: polymethyl methacrylate, polybutyl methacrylate, polyethyl methacrylate, polyvinyl acetate, polyvinyl pyrrolidone, polyvinylphenol, polyvinylchloride, polystyrene, polyethylene, polyvinyl alcohol, polycarbonate.

In certain embodiments, the method further comprises providing a substrate arranged to support the compressible layer.

Typically, this substrate will then form an integral part of a device manufactured using a method embodying the invention, the substrate supporting both the compressible layer and the layer of active material patterned with the insulative, further insulative, and optionally the additional insulative, features.

Thus, it will be appreciated that the active layer in certain embodiments is patterned with additional insulative features to define one or more devices and their associated properties/characteristics.

In certain embodiments, the substrate is substantially non-compressible.

In certain embodiments the substrate comprises a layer of material selected from a list comprising: glass (rigid or flexible); polymer (e.g. polyethylene naphthalate or polyethylene terephthalate); polymeric foil; paper; insulator coated metal (e.g. coated stainless-steel); cellulose; polymethyl methacrylate; polycarbonate, polyvinylalcohol; polyvinyl acetate; polyvinyl pyrrolidone; polyvinylphenol; polyvinyl chloride; polystyrene; polyethylene naphthalate; polyethylene terephthalate; polyamide (e.g. Nylon); poly(hydroxyether); polyurethane; polycarbonate; polysulfone; polyarylate; acrylonitrile butadiene styrene, 1-Methoxy-2-propyl acetate (SU-8), polyhydroxybenzyl silsesquioxane (HSQ), polyimide, Benzocyclobutene (BCB), Al₂O₃, SiOₓN_{y}, SiO₂, Si₃N₄.

In certain embodiments, the method further comprises providing a support surface, and supporting the compressible layer with the support surface during said displacing.

In such embodiments, the support surface can then be removed or separated from the compressible layer and active layer after patterning the active layer with the insulative, further insulative, and optionally the additional insulative, features. In certain embodiments the support surface is flat, but in other embodiments the support surface may have another shape, for example it may be curved. In certain embodiments, the support surface is the cylindrical surface of a support roller.

In certain embodiments, the layer of compressible material is arranged to support the layer of active material directly.

In certain embodiments, the method further comprises providing at least one intermediate layer of material between the layer of active material and the layer of compressible material.

In certain embodiments the intermediate layer of material may comprise or consist of material selected from a list comprising: self-assembled monolayer, siloxanes, thin-film inorganic oxide (e.g. alumina, silica, silicon sub-oxide) or nitride (e.g. SiN) or other materials which can selectively promote or discourage adhesion across the whole layer or can be patterned to provide regions of relatively good or poor adhesion as appropriate. The material choice would be determined by matching the hydrophobicity or hydrophilicity of the intermediate layer with that of the active material. The intermediate layer should be substantially insulating though it may be used to affect and/or control the charge carrier concentration within the active (e.g. semiconductor) material.

Suitable self-assembled monolayers could be selected from the following list: Organosilane such as 3-Aminopropyl-triethoxysilane, Trichloro(1*H*,1*H*,2*H*,2*H-*perfluorooctyl)silane [CF₃(CF₂)₅CH₂CH₂SiCl₃], Trichloro(3,3,3-trifluoropropyl)silane [CF₃CH₂CH₂SiCl_{3]},Triethoxy(1H,1H,2H,2H)perfluorodecylsilane [(CF₃)(CF₂)₇(CH₂)₂Si(OC₂H₅)₃], Octadecyltrichlorosilane [CH₃(CH₂)₁₇SiCl₃], Butyltrichlorosilane [CH₃(CH₂)₃SiCl₃], Trichloro(octyl)silane [CH₃(CH₂)₇SiCl₃] and Hexamethyldisilazane [CH₃)₃SiNHSi(CH₃)₃]. Other organosilane materials, which may be used in embodiments of the invention, are contained within the following articles: Nature Materials 3, 317 - 322 (2004); PRAMANA-JOURNAL OF PHYSICS, 67(1), pp 17-32, JUL 2006; J. Appl. Phys. 96, 6431 (2004).; Appl. Phys. Lett. 91, 192112 (2007).

Alternatively or in addition to the intermediate layer, other processing techniques may be used in embodiments of the invention to modify the surface (e.g. to improve adhesion of the active material to the compressible material and/or intermediate layer) prior to deposition or introduction of the active material. These include UV, plasma, ozone, corona discharge, piranha etch, and surface treatment such as described in EP1124791 or US7034129.

In certain embodiments, said displacing comprises pressing (urging) the or each selected portion towards the compressible layer using an embossing tool (which in certain embodiments may also be described as a stamp or shim).

In general, this embossing tool may take a wide variety of forms, and may be described as some means for positioning with respect to the active layer and then urging towards the layer of compressible material supporting the active layer so as to displace a selected portion or portions of the active material. The embossing tool may be arranged to produce the insulative features (this term encompassing the nominal insulative, further insulative, and additional insulative features) only by stamping (i.e. while any embossing surface of the embossing tool is in the process of pressing a portion of active material towards the compressible layer that surface is confined to moving only in a direction substantially perpendicular to the active layer; there is substantially no relative movement between the embossing surface and semiconducting layer in any direction along the active layer). However, in alternative embodiments, the embossing tool may be arranged so as to be moveable, whilst depressing the active layer (either directly or indirectly), in one or more directions substantially parallel to that layer so as to produce an extended insulative feature. In other words, whereas in certain embodiments the embossing tool may be arranged to produce insulative features by a pressing or stamping process, in alternative embodiments the embossing tool may be moveable so as to "write" insulative features in the substrate. Such written features can include insulative lines, for example.

In certain embodiments, the embossing tool comprises at least one embossing feature raised above a base surface, the method comprising urging the embossing tool towards the compressible layer such that each embossing feature displaces a respective selected portion of the layer of active material.

In other words, the embossing tool may comprise a plurality of embossing features, each corresponding to a respective insulative feature in the active layer of the manufactured device.

In certain embodiments, the embossing tool comprises a plurality of said embossing features arranged to define the pattern of the various insulative features in the active layer of the device.

In certain embodiments, the method further comprises using the embossing tool to displace a plurality of selected portions of the layer of active material in parallel.

In certain embodiments, the method comprises using the embossing tool to displace a plurality of portions of active material in parallel so as to define a plurality of insulative regions (and, optionally, one or more devices and/or interconnections between the devices) in the layer of active material in parallel (i.e. at the same time).

In certain embodiments, the method further comprises arranging the embossing tool such that the base surface is substantially planar, arranging the layer of active material to be substantially planar and parallel to the base surface, and urging the embossing tool towards the layer of active material such that each embossing feature displaces a respective selected portion of the layer of active material at the same time.

In certain embodiments, the embossing tool is substantially rigid.

In certain embodiments, the embossing tool is substantially flexible, the method further comprising supporting the embossing tool on a substantially planar (flat) support surface.

In certain embodiments, the method further comprises arranging the embossing tool such that the base surface lies substantially on the surface of a cylinder having a longitudinal axis, and rotating the embossing tool about said axis to pattern the layer of active material with the or each embossing feature of the tool.

In certain embodiments, the embossing tool is substantially flexible, the method further comprising supporting the embossing tool on a cylindrical surface (e.g. the surface of a support roller).

In certain embodiments, the embossing tool has a three-dimensional pattern or step created with two or more levels (e.g. the embossing tool may comprise a plurality of embossing surfaces arranged at a plurality of different heights with respect to a base surface), such as described in US patents 7056834 and 7202179, for example. In other words, the embossing tool may comprise stepped embossing features, at two or more heights or levels.

In certain embodiments, the layer of active material and the layer of compressible material are substantially flexible, the method further comprising supporting the layers of active and compressible material on a cylindrical support surface during said displacing.

In certain embodiments, at least one embossing feature comprises an embossing surface raised a distance d above the base surface. In certain embodiments, d can be in the range or ranges 10 to 3000nm. In certain embodiments, the or each embossing surface is substantially flat. In certain embodiments, the or each embossing feature has a substantially rectangular cross section. In certain embodiments, the or each embossing surface has a width w. In certain embodiments, w can be in the range or ranges 10 to 3000nm. In certain embodiments, d is substantially equal to w. In certain embodiments, d is >w. In certain embodiments, d is ≥2w. In certain embodiments, the aspect ratio of the embossing features can be even higher, for example d may be 3, 4, 5, 6 times greater (or even more), than w. In certain embodiments, the embossing tool comprises a plurality of embossing features, and wherein the minimum separation between any two of such embossing features is ≥w.

In certain embodiments, the embossing tool comprises at least one embossing surface, the method comprising using the or each embossing surface to press a respective selected portion of the layer of active material towards the compressible layer.

In certain embodiments, the method further comprises pressing the or each embossing surface directly against a respective portion of the layer of active material to displace that portion.

In certain embodiments, the method further comprises coating the or each embossing surface (e.g. with one or more coating materials) before using each coated embossing surface to displace a respective portion of the layer of active material.

In certain embodiments, the coating material is arranged to reduce adhesion between the embossing surface and the layer of active material, or an intermediate layer of material between the embossing surface and active material to improve the definition of the insulative features formed by the embossing technique. The use of a suitable coating material can reduce or even prevent the coating of the side walls of any trenches with active material, so helping electrically isolate the displaced portions from the undisplaced active material. The use of a suitable coating material can also reduce or prevent distortion of the nominally undisplaced layer of active material when the embossing tool is withdrawn (i.e. separated from the device pre-form).

In certain embodiments, the method further comprises providing at least one separating layers of material between the embossing tool and the layer of active material, and using the embossing tool to press the or each selected portion of active material towards the compressible layer through the separated layer or layers.

For example, the at least one separating layer may include a separating layer in the form of a non-stick or adhesion-reducing film used just in the manufacturing process, and/or the at least one layer of separating material may include a further device layer (such as a layer of insulative material) provided over the layer of active material. For example, the separating layers may include an upper layer, which together with the active layer, compressible layer, and any supporting layer beneath, form the eventual device or at least part of that device.

In certain embodiments, the method further comprises setting a temperature of the layer of active material to a predetermined value t1 before using the embossing tool to displace the or each selected portion.

It will be appreciated that controlling the temperature in this way can be used to various effects, such as to render the active material more flexible, to set the active material above or below a glass transition temperature, to embrittle the active material, etc.

In certain embodiments, the method further comprises setting a temperature of the embossing tool to a predetermined value t2 before using the embossing tool to displace the or each selected portion of active material. In certain embodiments, t1 = t2. In certain embodiments, t1 does not equal t2.

In certain embodiments, t1 > t2. Such a method can be used to selectively cool the portions of active material to be displaced. In certain embodiments, this selective cooling can be used to selective embrittle the layer of active material prior to displacement and improve electrical separation from the undisplaced active material.

In certain embodiments, t1 < t2. Such methods can be used to selectively heat portions of active material to be displaced, and in certain embodiments this can achieve selective softening of portions of the layer of active material.

Thus, in certain embodiments, the method may comprise controlling (e.g. setting) the temperature of one or more of the embossing tool and active layer before using the embossing tool to displace selected portions of active material and produce insulative features. In certain embodiments, the methods may further comprise the step of controlling and changing the temperature of at least one of the embossing tool and active layer whilst the embossing tool is in contact with the active layer or at least some intermediate layer between the two, and then withdrawing the embossing tool away from the active layer whilst this different temperature is maintained. This gives the device fabricator another adjustable parameter which can be tailored generally to improve the electrical characteristics of the insulative features produced by the embossing feature and/or reduce (even to zero) the number of post-processing steps required to complete the device or circuit.

In certain embodiments, the method further comprises controlling a force applied to pattern the layer of active material with the embossing tool. In certain embodiments, the method further comprises modulating said force (e.g. by pulsing the force, or in other words modulating its magnitude).

In certain embodiments, the method further comprises controlling a length of time for which the embossing tool is pressing the or each selected portion. In other words, in certain embodiments the method further comprises controlling a length of time for which the embossing tool is directly or indirectly in contact with the active layer before the end of the embossing step (i.e. before the embossing tool is withdrawn). This control may also take the form of controlling the speed of rotation of a roller supporting the embossing tool or layer of active material.

In certain embodiments, the method comprises pulsed-heating (e.g. by voltage, or other electrical, heating) of the embossing tool and/or pulsed pressure (i.e. modulation of the force applied to the embossing tool). This can improve the fidelity of the embossed features or structures.

For example, in certain embodiments the de-stamping (or withdrawal/separation of the embossing tool from the embossed "target" or object) can be done from a substantially cold material.

In certain embodiments, the method can comprise selectively heating the substrate, tool, or both.

In certain embodiments, the method comprises active cooling of the tool, for example prior to, or during contact with the target /object of the embossing process, such as to cool the tool before withdrawal/separation.

For example, certain embodiments comprise clamping an embossing tool to the target substrate at a desired temperature (e.g. room temperature, RT), then heating the arrangement to a desired higher temperature (e.g. 110 degrees C), then applying a desired force (e.g. 2000N) to exert a desired pressure (e.g. 500N/cm2), holding for a predetermined time (e.g. 30 minutes), then cooling the arrangement down to a desired temperature (e.g. RT), and then separating the tool from the embossed target at this temperature (e.g. RT).

In certain embodiments, the active material comprises at least one semiconductive material selected from a list comprising: polymer semiconductor, organic semiconductor, printable inorganic semiconductor, crystalline inorganic semiconductor, amorphous inorganic semiconductor.

Examples of polymer semiconductor include polyalkylthiophenes (e.g. P3HT), polyarylamines (e.g. PTAA), copolymers of fluorene and thiophene, polyparaphenylenevinylene (PPV). Other examples of n- or p-type organic semiconductor materials are described in the following references: J. Am. Chem. Soc., 2004, 126, 13480, Nature, 2009, DOI: 10.1038; Chem. Rev. 2007, 107, 953-1010; Chem. Rev. 2007, 107, 1066-1096 and US 7029945; Angew. Chem. Int. Ed. 2008, 47, 452 - 483 (precursor organic semiconductors); US2004038459A1, Nature Materials VOL 4 Aug 2005 p601, Nature Materials VOL 5 Dec 2006 p950, EP1579518A1 (blends of organic semiconductors with semiconductors).

Examples of organic conductors include polystyrenesulfonate doped poly(3,4-ethyelenedioxythiophene) - (PEDOT/PSS), polyaniline (PANI), polyfuran, polypyrrole or polycarbazole.

Other examples of organic conductors and semiconductors are described in the following articles: Current Applied Physics 3 (2003) 293-305.

Examples of organic insulators include polymethyl methacrylate, polyvinylalcohol, polyvinyl acetate, polyvinyl pyrrolidone, polyvinylphenol, polyvinyl chloride, polystyrene, polyamide (e.g. Nylon), poly(hydroxyether), polyurethane, polycarbonate, polysulfone, polyarylate, acrylonitrile butadiene styrene, 1-Methoxy-2-propyl acetate (SU-8), polyhydroxybenzyl silsesquioxane (HSQ), polyimide, benzocyclobutene (BCB). Other examples are described in the following: Chemistry of Materials (2004), 16(23), 4543-4555; Organic Electronics (2003), 4(1), 27-32; Advanced Functional Materials (2003), 13(3), 199-204.

The active material may optionally be chemically doped with one of the following:
For p-type: 2,3,5,6-tetrafluoro-7,7,8,8-tetracyano-quinodimethane (F4-TCNQ); WO₃, MoO₃ or V₂O₅; Lewis acids such as FeCl₃ or SbCl₅.; Ruthenium tris-(terpyridine), Tetrakis_(1,2,3,3a,4,5,6,6a,7,8-decahydro-1,9,9b-triazaphenalenyl)_ditungsten_(II));
For n-type: Acridine Orange Base (AOB, C17H19N3); Li; Cs; Rhodamine P and examples contained within: US 7161292, EP1837926, WO2007DE00587, EP1837927 (A1), WO2007107356, EP1643568 (A1), EP1538684 (A1), EP1860709 (A1), US2007278479, US2007148812, US2007145355

Examples of printable inorganic semiconductors include metal oxides such as indium tin-oxide, zinc oxide, titanium dioxide, indium zinc-oxide, gallium indium zinc oxide or metal oxides as described in Appl. Phys. Lett. 88, 123509 (2006) or WO2005112045; silicon inks such as described in US 7078276, US 6878184 and US7259100.

Examples of crystalline inorganic semiconductors include group IV semiconductors such as silicon, germanium or the like; III-V semiconductor such as gallium arsenide, indium phosphide.

Examples of amorphous inorganic semiconductors include amorphous silicon.

Doping or control of carrier concentration can also be achieved using induced dipole effects as described in UK patent application no.GB819684.2.

In certain embodiments, the semiconductive material is a precursor material, the method further comprising processing the patterned layer of semiconductive material to render the semiconductive material semiconducting.

In certain embodiments, the layer of compressible material comprises at least one compressible material selected from a list comprising polymethyl methacrylate, polybutyl methacrylate, polyethyl methacrylate, polyvinyl acetate, polyvinyl pyrrolidone, polyvinylphenol, polyvinylchloride, polystyrene, polyethylene, polyvinyl alcohol, polycarbonate.

Embodiments of the invention may be used in a method of manufacturing an electronic circuit comprising a plurality of electronic devices and a plurality of interconnections between the electronic devices in a single layer of semiconductive material, the method comprising:
providing a layer of semiconductive material, and a layer of compressible material supporting the layer of semiconductive material and
patterning the layer of semiconductive material with a plurality of insulative features, each insulative feature being arranged to interrupt the layer of semiconductive material and the pattern of insulative features defining the electronic devices and interconnections, and including at least one said insulative region (i.e. having an insulative perimeter and being divided into a plurality of parts by a plurality of substantially linear insulative features arranged as a grid) occupying a respective area of the layer,
wherein said patterning comprises:
   forming each insulative feature by a method comprising displacing a respective selected portion of the layer of semiconductive material towards the compressible material so as to compress compressible material under each displaced portion and separate at least partly each displaced portion from undisplaced semiconductive material.

It will be appreciated that the electronic circuit manufactured in this way may be described as a substantially planar electronic circuit.

Embodiments of the invention may also be incorporated in an electronic device comprising:
a layer of semiconductive material;
a plurality of insulative features, each arranged to interrupt the layer of semiconductive material (e.g. so as to at least inhibit current flow across the feature); and
a layer of compressible material arranged to support the layer of semiconductive material,
wherein the or each insulative feature comprises a respective selected portion of semiconductive material from the layer of semiconductive material, the respective selected portion being separated at least partly from adjacent semiconductive material of (or in) the layer of semiconductive material,
and wherein the plurality of insulative features define at least one said insulative region comprising an insulative perimeter surrounding an area of the semiconductive layer, and comprise a plurality of substantially linear insulative features arranged as a grid to divide said area into a plurality of parts at least partially electrically isolated from each other.

Embodiments of the invention may also be incorporated in an electronic circuit comprising, in a single layer of semiconductive material, a plurality of electronic devices and a plurality of interconnections between the electronic devices, and a layer of compressible material arranged to support the layer of semiconductive material, wherein the layer of semiconductive material is patterned with a plurality of insulative features, each insulative feature being arranged to interrupt the layer of semiconductive material and the pattern of insulative features defining the electrical devices and interconnections and at least one said insulative region, and wherein each insulative feature comprises a respective selected portion of semiconductive material from the layer of semiconductive material, the respective selected portion being separated at least partly from adjacent semiconductive material of the layer of semiconductive material.

In certain embodiments, the or each respective selected portion is displaced from the layer of semiconductive material in a direction towards the compressible layer such that the compressible layer has a higher density under the or each selected portion than under the undisplaced portions of the layer of semiconductive material.

Another aspect of the invention provides an electronic device or electronic circuit manufactured using a method in accordance with any other aspect of the invention.

For example, certain embodiments provide a ZnO planar nano transistor, with an on/off ratio of approximately 300, formed from a substrate structure comprising: ZnO (10nm)/PMMA (1000nm)/SiO₂/Si.

### Brief Description of the Drawings

Embodiments of the invention will now be described with reference to the accompanying drawings, of which:
Fig. 1 illustrates a sequence of three steps (steps A, B, and C) in a method useful for understanding the invention;
Figs. 2-5 illustrate insulative features formed in embodiments of the invention;
Figs. 6-11 show respective insulative regions formed in layers of active material and useful for understanding embodiments of the invention;
Fig. 12 is a schematic representation of another electrically insulative region formed in a layer of active material using a method embodying the invention;
Fig. 13 is a schematic representation of another electrically insulative region formed in an active layer using a method useful for understanding the invention;
Fig. 14 is a schematic representation of yet another electrically insulative region formed in an active layer using a method embodying the invention;
Fig. 15 is a schematic representation of yet another electrically insulative region formed in an active layer using an embodiment of the invention;
Fig. 16 is a schematic representation of a plurality of different insulative features formed in an active layer, each of these features being useable in embodiments of the invention;
Figs. 17, 18 and 19 illustrate different patterns of insulative features which may be used in methods and devices embodying the invention;
Figs. 20-22 illustrate the use of insulative regions embodying the invention to isolate devices formed on one region of an active layer from other regions;
Fig. 23 illustrates part of an active layer of material on which a plurality of insulative regions have been formed using methods embodying, or useful for understanding, the invention;
Fig. 24 illustrates part of an electronic device formed using an embodiment of the invention;
Fig. 25 illustrates another electronic device embodying the invention and incorporating insulative regions produced using methods embodying, or useful for understanding, the invention;
Fig. 26 is an atomic force microscope (AFM) image of a transistor embodying the present invention;
Fig. 27 is a microscope image of yet another electronic device embodying the invention;
Figs. 28 and 29 are AFM micrographs of an embossed receiver substrate before dry transfer of semiconductive material (P3HT) at 100°C in an embodiment of the invention.
Figs. 30a, 30b and 30c illustrate steps in a method of manufacturing an electronic device in accordance with the present invention;
Figs. 31a-31e illustrate the formation of insulative features in another method embodying the invention;
Figs. 32a and 32b illustrate the formation of an insulative feature in another embodiment of the invention;
Fig. 33 is a schematic cross section or part of an electronic device embodying the invention;
Fig. 34 is a schematic cross section of part of another electronic device embodying the invention;
Fig. 35 is a schematic cross section of yet another electronic device embodying the invention;
Fig. 36 is a schematic representation of part of an electronic device embodying the invention and embossing apparatus used to pattern the device;
Fig. 37 is a schematic representation of alternative embossing apparatus being used to pattern a layer of semiconductive material in a method embodying the invention;
Fig. 38 is a schematic representation of yet further embossing apparatus being used to pattern a layer of semiconductive material in a method embodying the invention;
Fig. 39 is a schematic representation of embossing apparatus and a device substrate in another method embodying the invention;
Fig. 40 is a schematic cross section of part of an electronic device embodying the invention;
Fig. 41 is a schematic representation of an embossing tool in the form of a stamp or shim, arranged to pattern a layer of semiconductive material in an embodiment of the invention;
Fig. 42 is a schematic representation of part of an embossing tool used in embodiments of the invention, the tool having an embossing surface provided with a raised pattern for producing corresponding insulative features in a semiconductive layer to define a complete electronic device;
Fig. 43 is a schematic representation of embossing apparatus used in another method of manufacturing electronic devices and embodying the invention;
Figs. 44-46 are schematic cross sections of different embossing features of embossing tools used in methods embodying the invention;
Fig. 47 is a schematic representation of an embossing tool arranged to produce an insulative feature in a device substrate in another method embodying the invention;
Fig. 48 is a schematic representation of another embossing tool arranged to pattern the semiconductive layer of an electronic device in another method embodying the invention;
Fig. 49 is a schematic representation of an embossing tool arranged to emboss a semiconductive layer via an intermediate layer or film in another method embodying the invention;
Fig. 50 is a schematic representation of embossing apparatus and substrate support apparatus used in methods of manufacturing electronic devices and circuits embodying the invention;
Fig. 51 is a schematic representation of an electronic circuit embodying the invention;
Fig. 52 is a schematic representation of a cross section of part of an electronic device embodying the invention;
Fig. 53 is a schematic plan view of an electronic device useful for understanding embodiments of the invention;
Fig. 54 is a schematic representation of an electronic circuit which may be manufactured using methods embodying the invention;
Fig. 55 is a schematic plan view of the circuit of Fig. 25 implemented in an embodiment of the invention (in other words Fig. 26 illustrates an electronic circuit embodying the invention;
Fig. 56 is an image of part of an electronic device embodying the invention;
Fig. 57 is a schematic representation of the cross section of part of an electronic device embodying the invention;
Fig. 58 is a microscope image of an insulative feature of an embodiment of the invention;
Fig. 59 is a schematic cross section of part of another electronic device embodying the invention;
Figure 60 is a cross section through a stamp and a device pre-form according to an embodiment of the invention,
Fig. 61 is a cross section through a device template prepared in accordance with the embodiment of the invention of fig. 31A,
Fig. 62 is a cross section through a stamp and a device pre-form according to a another embodiment of the invention,
Fig. 63 is a cross section through a device template prepared in accordance with an embodiment of the invention,
Fig. 64 is an image of a stamp suitable for use in a method embodying the invention,
Fig. 65 is an image of a device prepared using the stamp of Fig. 33;
Fig. 66 is a current/voltage plot for the device as shown in Fig. 34;
Fig. 67 is an image of a nano transistor embodying the invention and manufactured using a method embodying the invention;
Fig. 68 and 69 are output and transfer characteristics, respectively, of the transistor of Fig. 67;
Fig. 70 illustrates the formation of an insulative feature in certain embodiments;
Fig. 71 illustrates insulative features for use in embodiments of the invention;
Fig. 72 shows I-V characteristics of a diode device embodying the invention; and
Fig. 73 is an image of a side-gated transistor useful for understanding the invention.

### Detailed Description of Embodiments of the Invention

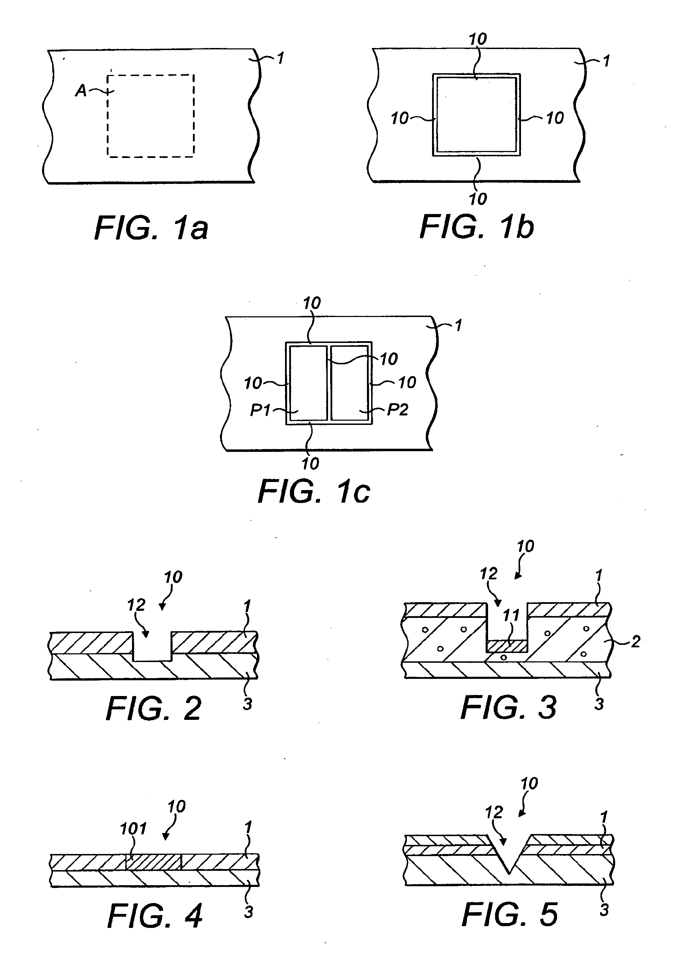

Referring now to Fig. 1, this shows a sequence of steps in the formation of an electrically insulative region from an area of a layer of electrically conductive or semiconductive material in a method useful for understanding the invention. In step A, the area A of the layer 1 of active material is shown. Then, in step B a plurality of insulative features 10 are formed to define an insulative perimeter around the area. In this example, each of these insulative features 10 is generally linear, and takes the form of a trench or channel cutting through the active layer 1. These linear insulative features 10 meet to form a rectangular perimeter around the area. It will be appreciated that although this insulative perimeter has been described as being formed from four insulative features, it could equivalently be described as being formed from a single insulative feature, that single insulative feature being a groove or trench formed as a rectangle around the area. Next, in step C, a further electrically insulative feature 10 is formed inside the perimeter to divide the area into two parts, P1 and P2. These parts are electrically insulated (i.e. isolated) from each other by the insulative feature 10 which runs through the centre of the area, connecting one side of the rectangular perimeter to the other. This further electrically insulative feature is again in the form of a groove or trench cutting through the layer 1 of active material. In this example, all of the linear insulative features 10 have substantially the same width and depth, although in alternative examples features having different widths and/or depths may be used together to define the insulative region.

It will be appreciated that Fig. 1 is highly schematic, its intention being to illustrate the general concept underlying embodiments of the invention.

Insulative features having a variety of forms may be employed in embodiments of the invention. Figs. 2-5 show just some of these possible forms. Referring to Fig. 2, this shows an insulative feature 10 in the form of a trench, groove or channel 12 having a rectangular cross section and which has been formed in a layer of active material 1 supported by substrate 3. The trench 12 extends down, and completely through the active layer 1, and into the substrate 3, so as to completely interrupt the layer 1 and prevent electrical conduction across the insulative feature 10. Such a trench or channel can be produced by a variety of known techniques. For example, machining or etching may be used, although other techniques will be apparent to the person skilled in this field. Referring to Fig. 3, this shows an alternative insulative feature. Here, the layer of active material 1 is supported on a layer of compressible material 2 (which in this example is compressible by virtue of including a plurality of pores). The combination of active layer 1 and compressible layer 2 is supported by a substantially non-compressible substrate 3. An insulative feature 10 in the form of a trench 12 has been formed by displacing a portion 11 of the layer of active material towards the substrate 3 so as to completely displace that portion 11 out of the layer 1 and compress some of the compressible material 2 underneath it. The compressible layer 2 has thus yielded, enabling the portion 11 to be completely driven out of the plane of the active layer 1 and so achieve good electrical isolation across the feature 10. Referring now to Fig. 4, this shows an alternative form of insulative feature 10. Here, a selected portion 101 of the active material from the layer 1 has been processed in some manner so as to reduce its electrical conductivity. This reduction can, in certain embodiments, be a reduction substantially to zero, although in alternative embodiments it may only be a partial reduction. Again, the active layer 1 is supported on an insulating substrate 3. This selective reduction in conductivity can be achieved by any suitable means. For example, if the layer 1 is of semiconductive material, the processing to produce region 101 can be a processing suitable to effectively remove any charge carriers from that portion.

Referring now to Fig. 5, this shows another insulative feature in the form of a V-shaped groove 12 formed in a multi-layer structure comprising an upper layer, a layer 1 of active material, and an insulating substrate 3. The V-shaped groove 12 has completely cut through the active layer 1 under the upper layer, and extends down into the substrate 3 to provide good electrical isolation across the feature 10.

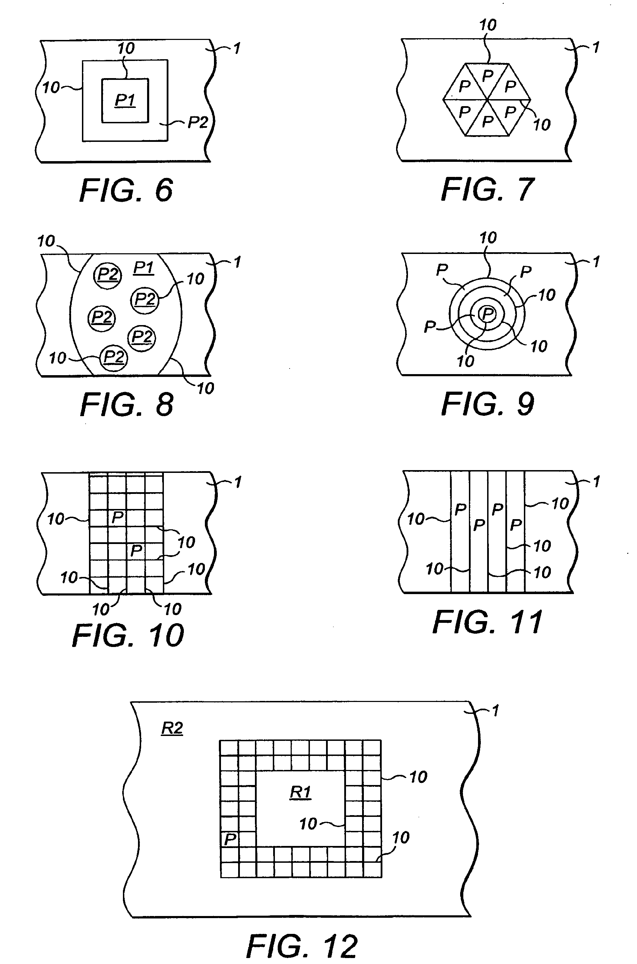

Referring now to Figs. 6-12, in these figures the various insulative features 10 are shown simply as solid black lines. This is merely to simplify the figures, and it will be appreciated that in practice these insulative features have a finite extent, for example each being provided by a suitably arranged channel, groove, trench, or other depression in the layer 1, or by a suitable portion of previously active material rendered non-conducting by appropriate processing.

Referring to Fig. 6, here a generally rectangular insulative feature 10 has been formed to define an outer perimeter enclosing an area of active material from the layer 1. Another insulative feature 10 has been formed within that outer perimeter to define an inner perimeter surrounding a portion P1 of the area. Thus, the inner insulative feature 10 electrically isolates central portion P1 from surrounding portion P2 of active material within the outer perimeter. These two portions are themselves electrically isolated from the outside active layer material.

Referring now to Fig. 7, a generally hexagonal insulative perimeter has been formed from a connected plurality of linear insulative features. The area of active material inside this hexagonal perimeter has been further subdivided into six parts, each labelled P, by a plurality of crossing (intersecting) further linear insulative features.

Referring now to Fig. 8, here a pair of curved insulative features 10 have been formed to extend fully across a layer of active material 1. In the area defined inside these curved features, further insulative features have been formed, each in the form of an insulative ring. Each portion of active material P2 inside each ring is electrically isolated from the other circular portions P2 and from the portion P1 of active material inside the outer features.

Referring now to Fig. 9, this shows an arrangement in which the insulative features take the form of a plurality of concentric rings, separating a circular area of the layer of active material 1 into a middle, circular portion, and a series of annular portions of increasing diameter.

Referring now to Fig. 10, this shows an electrically insulative region extending fully across the width of a layer of active material 1. Linear insulative features extending fully across the layer have been used to define part of an outer perimeter, and the area of substrate inside the perimeter has been further subdivided by a rectangular array of insulative features. This grid-like array divides the area into a plurality of individually isolated parts P, and each of these parts can be regarded as an island of active material, electrically separated from all of the other islands.

Referring now to Fig. 11, this shows an arrangement in which an area of active material has been subdivided by a plurality of parallel linear insulative features, the area of active material thus being divided into a plurality of parts P, each in the form of a strip.

Referring now to Fig. 12, here an electrically insulative region has been formed so as to surround a region R1 of active material from the layer 1 and thus electrically isolate that region R1 from an outside region R2. The insulative region can thus be regarded as being generally annular. The insulative region is defined by a plurality of generally linear insulative features arranged to meet, cross, and intersect each other appropriately to give the required isolation. These linear insulative features define an outer perimeter and an inner perimeter, the inner perimeter enclosing region R1. The insulative region as a whole is thus formed from the area of active material located between the outer and inner perimeter. This area is further subdivided into a plurality of small squares or other rectangles by the array of insulative features.

It will be appreciated that in certain embodiments, region R1 may be a region in which one or more electrical and/or electronic devices are located, and a further device or devices may be located in region R2.

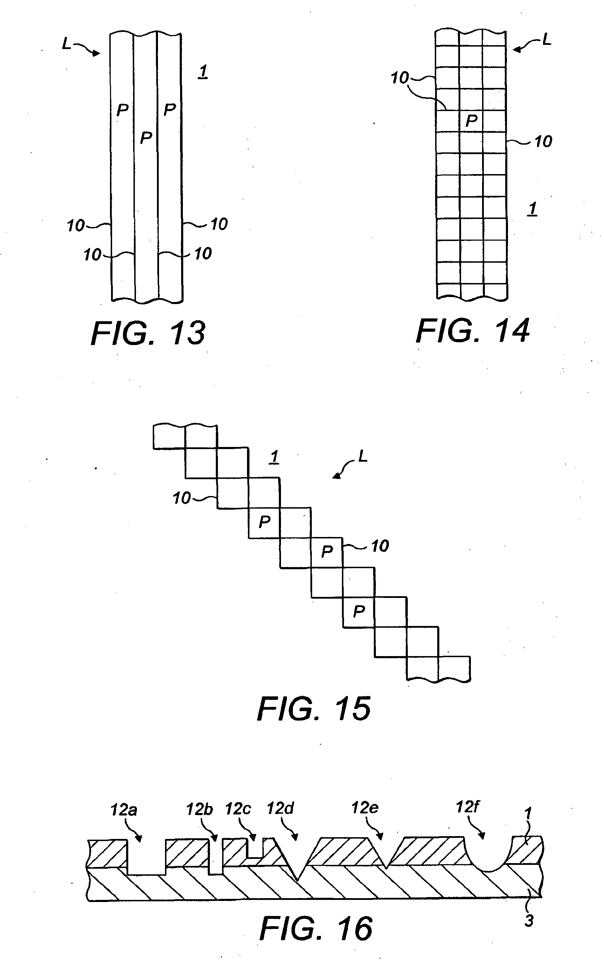

Referring now to Fig. 13, this shows part of an electrically insulative region produced by a method useful for understanding the invention.

This insulative region is in the form of a line L extending along part of a layer 1 of active material. The insulative features defining the region are themselves generally linear and parallel to one another, such that the region defined inside the perimeter of the line L comprises a plurality of strips P electrically insulated from each other, i.e. electrical conduction from one strip to an adjacent strip is prevented in this example. Although the line L in this example is a straight line, it will be appreciated that in alternative examples the insulative region may take the form of a line of a different shape, such as a curved line. Then, either straight linear insulative features or curved insulative features may be used to subdivide the region into the plurality of "islands" of active material.

Fig. 14 shows part of an alternative insulative region formed using a method embodying the invention and again taking the form of a generally straight line L. In addition to insulative features 10 running along the length of the line L, the region also comprises a plurality of transverse insulative features, dividing the strips of active material between the longitudinal lines into a plurality (in this case a rectangular array) of generally rectangular islands of material. In this example the transverse insulative features are again generally straight lines, although in different embodiments different geometries of insulative features may be used.

Fig. 15 illustrates another insulative region embodying the invention, and again taking the general form of a line L. This insulative feature has been formed in the active layer 1 by an array of generally linear insulative features crossing and meeting each other to define a plurality of insulative rectangular islands P, the line L formed by the lines (or equivalently by the component squares P) is generally diagonal in this example with respect to the geometry of the rectangular islands P. This illustrates how different shapes of insulative regions on the active layer 1 may be built up, even when the geometries at which individual insulative features may be formed on the layer 1 are restricted.

Fig. 16 is a highly schematic illustration of some examples of insulative features which may be formed in (i.e. utilised in) methods embodying the invention. In this figure the insulative features have been formed in a multi-layer device structure, which comprises a layer of active material 1 supported by an insulative substrate 3. Each insulative feature is in the general form of a trench, channel or recess formed in the active layer 1. A first channel 12a is generally rectangular, having been formed with substantially straight and vertical side walls extending down through the active layer 1 and partially into the supporting substrate 3. The channel 12a has a flat base surface in the substrate 3. This channel 12a completely interrupts the active layer 1 that has been formed by removing the active and substrate material completely from the region defined by the eventual trench. This insulative feature 12a thus provides complete electrical isolation in terms of preventing current flow within the layer 1 across the trench 12a. A second insulative feature is again a rectangular trench 12b, having the same depth as the first trench 12a, but being narrower. In methods embodying the invention, combinations of trenches of different widths and/or depths may be used in combination to define electrical/electronic properties of the processed layer 1. Another insulative feature is a shallower, rectangular trench 12c. This extends only partially through the active layer 1, and so does not provide complete electrical isolation from one side of it to the other. However, it does result in the thinner portion of active material under it presenting a higher resistance current path as compared with regions of completely uninterrupted active layer 1. Feature 12c thus represents a partial interruption to the active layer 1, and may be used in embodiments as required to give appropriate electrical/electronic properties. Insulative features in the form of trenches need not be rectangular in embodiments of the invention, and examples of such non-rectangular trenches are shown in Fig. 16 as items 12d, 12e, and 12f. 12d is a generally V-shaped groove, extending completely through the active layer 1 and into the substrate 3. A second V-shaped groove 12e is shallower, extending just through the active layer 1 to meet the substrate 3. It will be appreciated that various techniques for producing features 12d and 12e, (and indeed all of the features 12a-f in Fig. 16) may be used in embodiments of the invention, such as embossing, stamping, etching, laser ablation, etc.

Moving on to feature 12f, this is a groove with curved sides, formed in the active layer 1 to completely interrupt the layer by extending into the substrate 3.

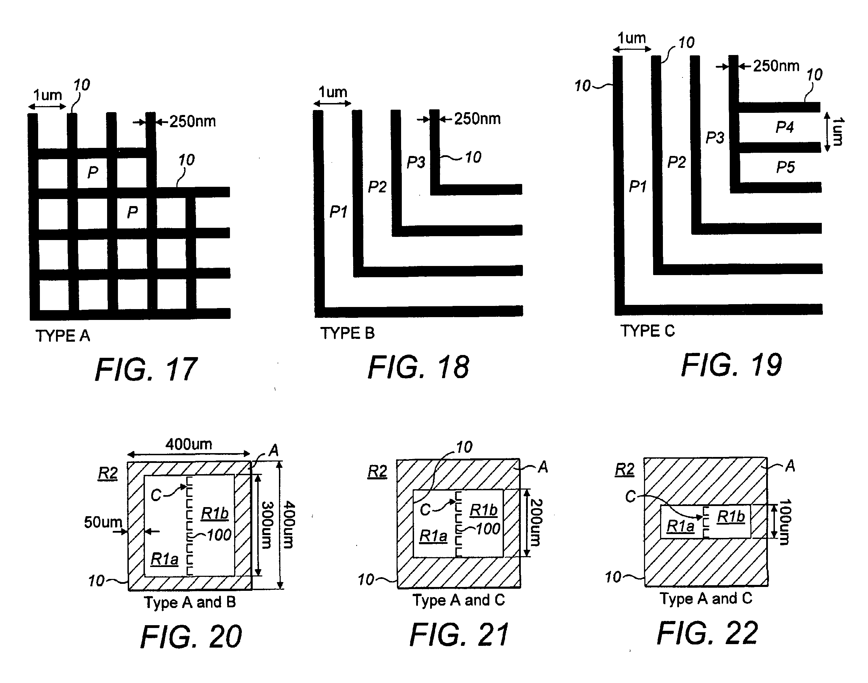

Referring now to Figs. 17, 18 and 19, these show different arrangements of insulative features 10 which may be used to produce insulative regions in methods and devices embodying the invention. Fig. 17 illustrates an arrangement of insulative features which will be referred to as type A, where the insulative features 10 are each generally linear and are arranged to form a rectangular grid. Such a grid is useful for defining an insulative region from various shapes and sizes of areas of active material. In this example, each insulative feature has a width of 250 nm, and the separation between adjacent linear insulative features is 1 um. Fig. 18 shows an arrangement of insulative features which will be referred to as type B, in which the component insulative features (which can be referred to as elements) are straight lines, parallel to their neighbours. The insulative lines 10 are shown defining a corner of an insulative region. The features 10 thus define a series of portions P1, P2, P3 of active material inside the overall perimeter which are nested. It will be appreciated that the insulative features in Fig. 17, 18 and 19 may take a variety of forms in different embodiments of the invention. For example, they may be trenches, channels, or grooves, they may be filled trenches, channels, or grooves, or they may be selected regions of the active layer which have been rendered completely non-conductive, or less conductive by appropriate processing. Other forms of features 10 will be apparent to the person skilled in this field.

Moving on to Fig. 19, this shows an arrangement of insulative features which we will refer to as type C. This arrangement is similar to the type B arrangement, but is suitable for use where the insulative region to be formed does not have uniform width. In addition to the insulative features forming the nested portions P1, P2 and P3, further linear features 10 are employed to define islands P4 and P5.

Referring now to Fig. 20, this shows an insulative region formed from an area A of active material to surround a region R1 of active material and separate that region R1 from a second region R2 outside the area A. The insulative feature is thus generally annular, and has uniform width of 50 um. Region R1 is generally square, with a side length of 300 um, and the outer perimeter of the insulative region forms a square of side 400 um. In side region R1, a number of additional insulative features 100 have been formed to define a plurality of narrow conductive channels C, these channels C connecting one half R1A of the surrounding region to another half R1B. These channels C are arranged such that the entire region R1 exhibits diode-like characteristics when a potential is applied between region R1A and region R1B. In other words, the features 100 and the inner perimeter of the insulative region define a diode on the active layer 1. The electrical characteristics of such a diode and information on how to form the insulative features 100 to give desired characteristics are known in the prior art. In Fig. 20, the insulative region formed from area A is to electrically isolate the diode from the surrounding region R2. To form the insulative region, further insulative features (that is in addition to the insulative lines 10 forming the outer and inner perimeters) are formed to further subdivide area A and provide good isolation between regions R1 and R2. For example, an array of insulative lines of type A described above may be used. Alternatively, an array of type B may be used as the area A has uniform width, so as to divide the area A into concentric square rings, in which case the insulative region would not embody the invention. These are just examples, however, and other arrangements of insulative features may be employed to subdivide area A in alternative examples.

Moving on to Fig. 21, this shows part of another electronic device, in which an insulative region has been formed from an area A of an active layer to define a region R1 inside an inner perimeter and a region R2 outside an outer perimeter. Inside region

R1, there is again an array of further insulative features 100 defining a plurality of channels C so as to define a region of active material functioning as a diode. This region R1 has a width of 200 um, such that the area A does not have uniform width around region R1. Although not shown in the figure, area A in embodiments of the invention can be further divided by insulative features in a type A arrangement, or a type C arrangement can be used (in which case the insulative region would not embody the invention) as described above.

Similarly, Fig. 22 shows another portion of a layer of active material. The region R1 surrounded by the area A adapted to form an insulative region is even narrower in this example, having a width of just 100 um. Again, insulative features in type A or type C arrangements may be used to form the insulative region from area A.

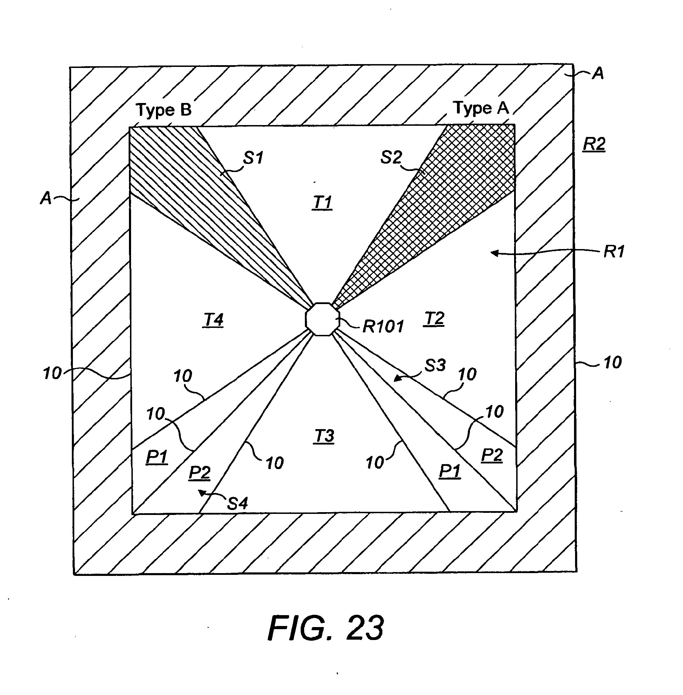

Referring now to Fig. 23, this is a schematic representation of a variety of insulative regions being used to separate one region R1 of an active layer from another region R2, and to define further insulative regions to define device terminals within the inner region R1. A surrounding area A of active material has been processed to form a correspondingly-shaped insulative region using a method embodying the invention. Inside an inner perimeter of area A another insulative region has been formed from a sector S1 of active material. This sector S1 has been formed into an electrically insulative region by forming a plurality of insulative features in a type B pattern as described above. Thus, insulative lines form the edges of the sector S1, and parallel insulative lines further subdivide the sector. A second sector S2 has been formed into an insulative region by patterning it with insulative features in type A fashion. Thus, sector S2 is finally subdivided into squares or other rectangles by a grid or mesh of insulative lines, within its overall insulative perimeter

A third sector S3 has been adapted to form an insulative region by means of insulative features (each linear in this example) defining a perimeter of the sector S3 and further subdividing the sector into two separate parts P1 and P2. Similarly, sector S4 has been adapted to form an insulative region by a further plurality of insulative features 10 which combine with the inner insulative perimeter surrounding area A to separate sector S4 into first and second parts or portions P1, P2 of active material, electrically isolated from one another. These insulative sectors S1, S2, S3, and S4 are used to define four electrically separated terminal areas T1, T2, T3, and T4. Although not shown in the figure, a central portion R101 of region R1 is patterned with additional insulative features to define an electronic device or devices using techniques known in the prior art. For example, the octagonal central area can contain insulative features to define a side-gated transistor with T1 and T3 acting as gate terminals with one of T2 and T4 as source and the other of T2 and T4 as drain terminals. The terminals T1-T4 enable connections to be made easily to these relatively large terminal areas, the terminal areas themselves connecting to the relevant portions of the active device in the central portion.

It will be appreciated that Fig. 23 serves to demonstrate the four sector insulating areas. In alternative examples these can be one of type A, B or C rather than a mix. Thus, in other examples the lower sections S3/S4 could employ the same pattern of insulative features as S1/S2.

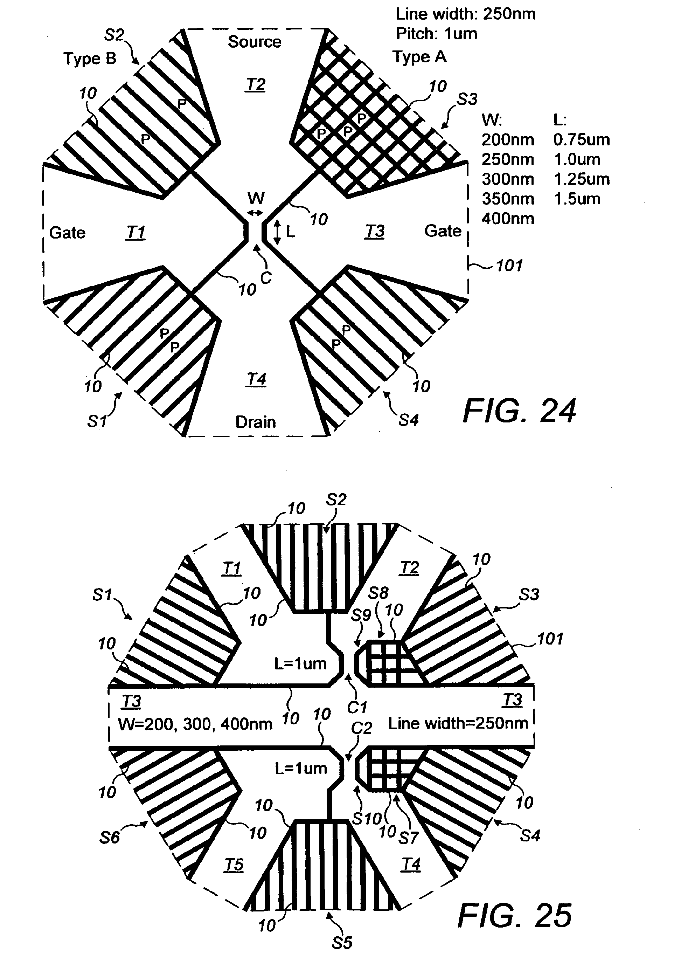

Referring now to Fig. 24, this shows a field effect transistor (FET) embodying the invention and formed from a region 101 of a layer of semi-conductive material supported by a substrate (not shown). The region 101 has been provided with a plurality of insulative features 10 using methods embodying the invention. Insulative features generally towards the centre of the device define a conductive channel C of semiconductive material having a width W and a length L. Various dimensions may be used for this width and length in different embodiments of the invention. For example, the width may be 20, 250, 300, 350 or 400 nm and the length may be 0.75, 1.0, 1.25, or 1.5 um. These are merely examples, however, as will be appreciated. The conductive channel C provides a connection between a source region (which can also be described as terminal area T2) and a drain region (terminal T4). Gate regions (terminal areas T1 and T3) are defined on either side of the channel C, and a conductivity of the channel C can be modulated by application of voltages to one or more of the gate regions T1 and T3. Electrical isolation between the different terminals is provided by insulative regions or sectors S1, S2, S3, and S4. In each of these sectors, respective insulative features define a respective insulative perimeter, and further insulative features are provided to sub-divide those sectors into electrically separated portions P of the semi-conductive material. Only some of these portions P are shown on the figure, for clarity. Different patterns of insulative features 10 are used in the different sectors. For example, a grid pattern of features 10 (i.e. a type A pattern) is used to form insulative sector S3. Arrays of parallel insulative features 10 (i.e. type B patterns) are used to define insulative regions S2, S4, and S1. In this particular example, each insulative feature 10 is a line of width 250 nm, and the pitch is 1 um. Again, these are merely examples, and other line widths and pitches may be used in alternative embodiments. Again, in other examples, the same pattern of insulative features may be used to define each insulative region (sector) rather than using a plurality of different patterns. In general, examples may employ a single pattern, or a plurality of different patterns of insulative features to define a plurality of insulative regions.

Referring now to Fig. 25, this is another electronic device embodying the invention, and formed from a region 101 of a layer of active semiconductive material. The device is defined by the pattern of insulative features 10 formed in the semiconductive layer (i.e. to selectively interrupt it). The device shown is an inverter having terminals T1-T5 and comprising two conductive channels C1 and C2, each having a width W and a length L. In addition to insulative features 10 defining these channels C1 and C2, the device comprises further insulative regions S1-S8. These regions are arranged to provide electrical isolation between the respective terminal areas T1-T5. Different patterns of insulative features are used to form this plurality of insulative regions. For example, parallel arrays of insulative lines are used to form insulative regions S1-S6. Grid arrays of lines are used to form insulative regions S7 and S8. Further regions S9 and S10 immediately adjacent the conductive channels C1 and C2 are defined by just an insulative respective perimeter. Terminal area T1, defined between insulative regions S1 and S2, can be regarded as a second input to the inverter, or alternatively can be used as a floating input. Terminal area T5, between insulative sectors S6 and S5 can be regarded as a first input. In use, terminal area T4 may be connected to earth or ground, and terminal area T2 may be arranged to be provided with a supply voltage. Terminal T3 can then be regarded as an output terminal. Again, various dimensions for the channel widths and lengths may be used in embodiments of the invention. For example, each channel may have a length of 1 um, and the channel width may be 200, 300 or 400 nm. The width of each insulative feature 10 may be 250 nm, for example.

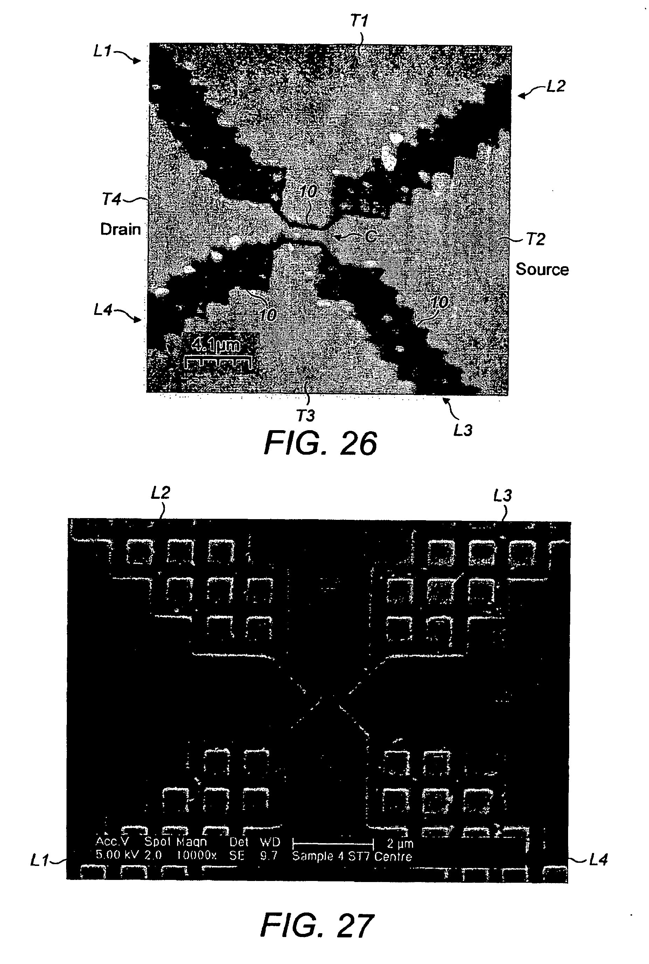

Referring now to Fig. 26, this shows another electronic device embodying the invention and formed in an active layer of semiconductive material supported by a substrate. The device is a FET, having a conductive channel C connecting a source region T2 to a drain region T4. Gate regions T1 and T3 enable a potential difference to be applied so as to modulate the electrical conductivity of the channel C. In this embodiment, rather than the terminal areas being separated by insulative sectors, the terminal areas are separated by insulative features in the form of insulative lines L1-L4, each line being formed from a honeycomb-like arrangement of cells, each cell comprising a portion of active material surrounded by an insulative perimeter. In this example, each cell is generally square, although it will be appreciated that in alternative embodiments insulative features may be built up from cells having different shapes. The scale of the insulative features is indicated on the figure. In this example, the insulative features 10 have been formed in parallel by an embossing technique. The layer of active material was supported on a compressible "buffer layer", itself supported on a non-compressible substrate. The buffer layer used in this example was high molecular weight PMMA (with an average molecular weight of approximately 950k). A suitably patterned embossing tool was used to form each insulative feature 10 by displacing a respective portion of active material down into the compressible buffer layer so as to separate that displaced portion from the undisplaced active material. The honeycomb arrangement of insulative features to form each insulative region provides the advantage that a small number of imperfections in the electrical isolation technique can be tolerated whilst still providing the insulative regions as a whole with sufficiently insulating properties. In other words, manufacturing defects may mean that there is the occasional electrical bridge between one island of active material and an adjacent island. However, as each insulative region is formed from a large number of such cells, individual electrical bridges do not necessarily compromise the insulating properties of the region as a whole.

Referring now to Fig. 27, this shows a microscope image of yet another transistor embodying the invention. Here, the channel is so short that it, in effect, defines just a gap G. Terminal regions T1 and T3 are again useable as gates to apply a potential to modulate the electrical properties of the gap, which itself connects source and drain regions T2 and T4. Insulative regions in the forms of lines L1-L4 are again used to separate the various terminal regions, and each line comprises a respective rectangular array of insulative lines, dividing the area of active material occupied by each line into a respective plurality of individually isolated islands P. In this example, the layer of active material is a layer of P3HT, supported on a compressible layer of PMMA, itself supported on a substrate of SiO₂. The pattern of insulative features 10 was formed by embossing the P3HT layer. An embossing tool, patterned with the plurality of insulative features so as to be able to produce the device, including insulative regions L1-L4 (in a single pressing step) was used, and urged into contact with the P3HT layer with a pressing force of 1.5 kN. The embossing was performed at a temperature of 85°C. As can be seen from the microscope image of Fig. 27, this embossing technique produced well-defined insulative features 10, and hence well-defined electronic properties for the resultant device. The embossing was such that each insulative feature 10 was formed by displacing a respective portion of the active P3HT material down into the compressible layer of PMMA, effectively separating that portion from undisplaced semiconductive material in the main layer.

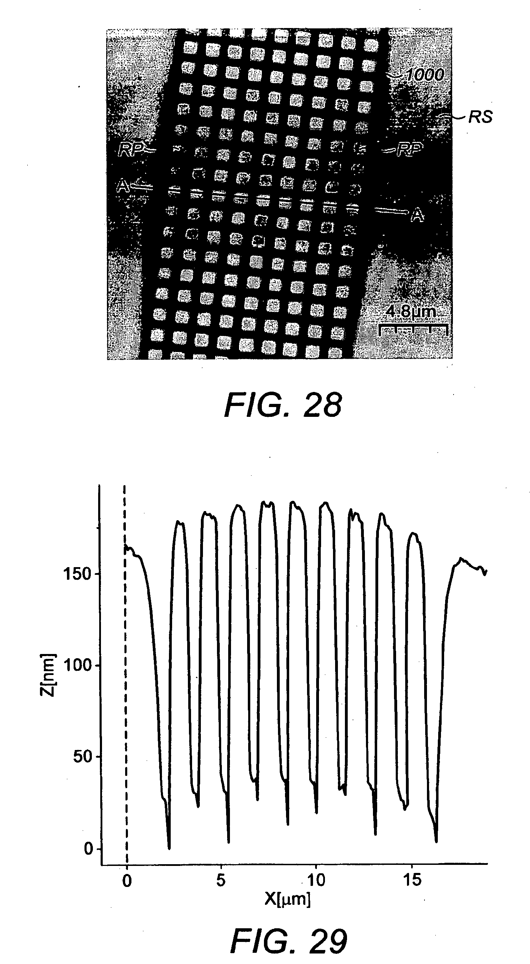

Referring now to Figs. 28 and 29, Fig. 28 illustrates a step in the production of an insulative feature in a method embodying the invention. Fig. 28 can also be described as illustrating a step in the production of a semiconductive device embodying the invention. Looking at Fig. 28, this shows part of a surface of a receiver substrate RS, which has been patterned with a grid array of trenches 1000 which has divided an area of the receiver substrate into a plurality of separated receiving portions RP. Fig. 29 is a micrograph illustrating surface height of the receiver substrate surface along line A-A in Fig. 28. This array of trenches 1000 can be produced using a variety of techniques, but in certain embodiments of the invention it is produced by embossing the surface of the receiver substrate with a suitable stamp or embossing tool. As a next step towards the production of an insulative feature in a layer of active material, the patterned surface shown in Fig. 28 is brought into contact with a layer of active material suitably provided on a carrier substrate. Then, the carrier substrate is withdrawn, leaving active material deposited just on the top surfaces of the receiver substrate, i.e. no active material is deposited inside the grooves or trenches 1000. It will be appreciated that the resultant structure then comprises a layer of active material which coats the uninterrupted portions of receiver substrate on either side of the grid of trenches, and indeed coats the top of each receiver portion RP. However, the insulative trenches 1000 which were produced in the receiver substrate before transfer of active material from the carrier substrate are electrically isolated from one another. A method utilising the technique shown in Fig. 28 provides the advantage that the grid of trenches 1000 can be produced by an embossing technique and can provide a relatively large insulative feature in the eventual device by dividing the relevant area of the receiver substrate into small, separated portions RP.

Although in certain embodiments of the invention a receiver substrate may be patterned using an embossing or stamping technique, it will be appreciated that alternative techniques may be used in alternative embodiments to give the same effect, namely that, after the patterned receiver substrate has been brought into contact with active material provided on a carrier substrate, when the carrier substrate is then separated/withdrawn, active material is selectively left behind on the receiver substrate in a pattern defined by the pattern with which the receiver substrate was itself patterned.

Thus, in certain embodiments, the formation of the insulative features to define and subdivide the electrically insulative region (and/or to define device characteristics, performance and interconnections) comprises: providing a substrate having a substantially uniform surface; patterning said surface; providing an unpatterned layer of active material on a carrier substrate; and forming a correspondingly patterned layer of active material on the patterned substrate surface by urging the substrate and carrier substrate together so as to bring the patterned substrate surface into contact with the unpatterned layer of active material, and then separating the substrate and carrier substrate. Clearly, the pattern defines the insulative features in the active layer, which in turn define the insulative region(s).

A number of further embodiments of the invention will now be described. For simplicity, the method of production of a just a single insulative feature is described for some of these embodiments, but it will be appreciated that a number of such features will be formed in practice, to define at least one insulative region comprising an area of active material, surrounded by an insulative perimeter, and divided into a plurality of separate parts or portions by a plurality of substantially linear insulative features arranged as a grid inside that perimeter. It will also be appreciated that insulative lines incorporated in the embodiments described below may take the form of elongate insulative regions, themselves having insulative perimeters and having internal structure (e.g. in the form of arrays of yet finer insulative lines, separating the constituent active material into a plurality of isolated islands.

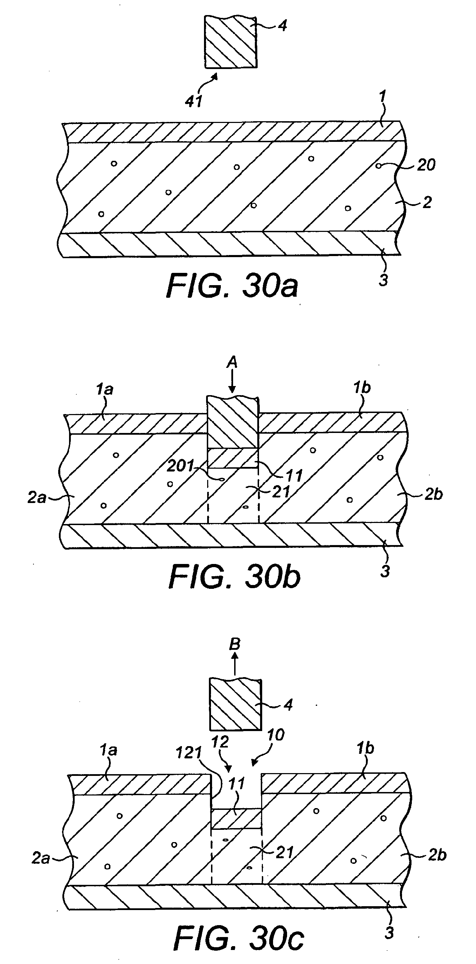

Referring now to Figs. 30a-30c, in a method embodying the invention a layer of semiconductive material 1 is provided, supported by a layer 2 of insulative and compressible material.

The insulative layer 2 is itself supported by an underlying substrate layer 3, in this example formed of substantially non-compressible material. The semiconductive layer 1, compressible layer 2, and substrate or backing layer 3 can together be described as forming a multi-layer device substrate. It will be appreciated that a wide variety of techniques known in the art may be used to fabricate such a multi-layer structure, and embodiments of the invention may utilise any suitable such techniques, for example techniques selected to suit the particular material or materials of each layer. In certain embodiments, for example, the semiconductive layer 1 is a layer of organic semiconductive material, which may be formed over the compressible layer by spin-coating. In this example, the material of the compressible layer 2 is porous, that is comprising a plurality of pores 20, and having an initial porosity. Fig. 30a shows an embossing tool 4 having an embossing surface 41 and arranged over the semiconductive layer 1 to be patterned, ready to form an insulative feature. Fig. 30b illustrates a subsequent step in the manufacturing method, in which the embossing tool 4 has been moved in a direction generally towards the compressible layer 2 (and hence towards the backing layer 3), that direction being generally indicated by arrow A. In making this movement, the embossing surface 41 has engaged a corresponding portion of the upper surface of the semiconductive layer 1, and has driven a selected portion 11 of the layer of semiconductive material 11 downward, out of the plane of the initial layer 1, and compressing a portion 21 of the compressible material beneath it. This compression has formed compressed pores 201 in the portion 21, and it will be appreciated that compressed portion 21 has a reduced porosity and increased density compared with uncompressed portions 2a and 2b. In this example, this displacement of the selected portion 11 of semiconductive material has completely separated it from undisplaced portions 1a, 1b of the semiconductive layer 1. Fig. 30c shows another subsequent step in the manufacturing method, in which the embossing tool 4 has been withdrawn, in direction shown by arrow B, leaving the displaced portion 11 of semiconductive material at the bottom of a depression or trench 12 formed in the upper surface of the device substrate. The material of the compressible layer 2 in this example is such that the compression of the portion 21 is substantially irreversible, such that there is substantially no return of the portion 21 to its original dimensions. In other words, the compressible material 2 has been arranged to yield under the force applied via the embossing tool, and remains in its compressed state. In this example, the side walls 121 of the trench 12 comprise exposed portions of the layer of insulative, compressible material 2 such that the insulative feature 10 formed by the embossing tool 4 (and which comprises the trench and displaced portion 11 of semiconductive material) forms a substantially complete electrical block to current flow in the semiconductive layer 1 across the feature 10.

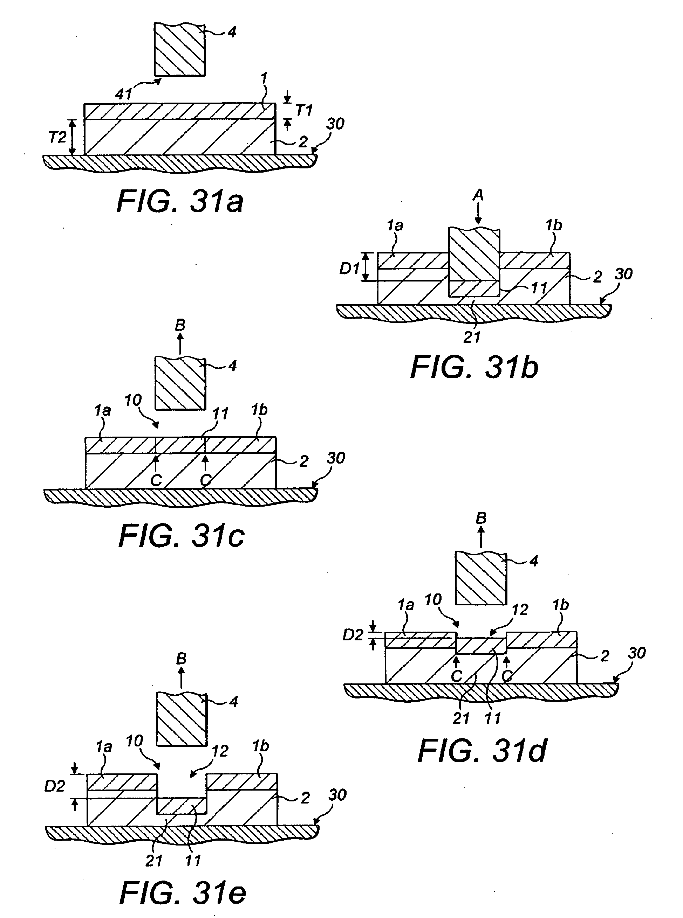

Referring now to Figs. 31a-31e, in another method embodying the invention a device multi-layer substrate comprises a layer of semiconductive material 1 formed on a layer of compressible material 2 without any incompressible backing layer or layers. Instead, during the patterning process to produce insulative features the device substrate is temporarily supported on a support surface 30, which in this example is flat. The semiconductive layer has been formed to have a substantially uniform thickness T1, and the compressible material has been formed so as to have a substantially uniform thickness T2. Again, an embossing tool 4 having an embossing surface 41 is arranged to produce insulative features by a stamping process alone, i.e. by movement solely in a direction substantially perpendicular to the flat support surface 30. Fig. 31a shows the embossing tool 4 positioned ready to emboss the device substrate. Fig. 31b shows a subsequent point in the manufacturing process, at which the embossing tool 4 has been urged towards the support surface 30 in the direction shown by arrow A so as to press and displace the selected portion 11 of semiconductive material from the layer 1 towards the support surface 30, compressing a portion 21 of the compressible material beneath it. In this example, the embossing tool 4 has been used to displace the portion 11 initially by a distance D1, where D1 is greater than T1, and less than T2.

Fig. 31c shows a subsequent step in the method where the compressible material used to support the semiconductive layer is so resilient that it substantially returns to its original shape when the embossing tool 4 is withdrawn in the direction shown by arrow B. The portion of semiconductive layer 11 initially displaced by the tool 4 has also substantially returned to its original position, in the layer of semiconductive material 1 and substantially co-planar with the undisplaced portions 1 a, 1b. However, the earlier displacing operation has produced discontinuities C (which may be in the form of cracks, cuts, faults, or other such features) which at least partially define and separate the "displaced" portion 11 from the undisplaced semiconductive material. These discontinuities (brakes, cuts, etc) C at least inhibit, and in some embodiments will completely prevent, the flow of current in the layer 1 from an undisplaced portion 1 a on one side of the displaced portion 11, to an undisplaced portion 1 b on the other side. Thus, even though the portion 11 has returned substantially to its original position, the embossing process has still produced an insulated feature 10, that feature comprising the displaced and returned portion 11, but also the discontinuities C on either side.

Fig. 31d illustrates an alternative subsequent step in the manufacturing method, following the steps shown in Figs 31 a and 31 b, but where the compressible material 2 has been selected so as to be partially resilient. In other words, the compression of the portion 21 has been arranged such that the resultant deformation of the compressible material has included both a reversible component and an irreversible component (which may also be described as a yielding component, an inelastic deformation, or a plastic deformation). Fig. 31d illustrates again the situation where the embossing tool 4 has been withdrawn. The compression portion 21 has partly regained its original shape, but not completely. As a result, displaced portion 11 remains partly offset from the undisplaced portion 1a and 1b of the semiconductive layer, forming the base of a trench or depression 12 in the upper surface of the device. Although there is some overlap between the sides of the displaced portion 11 and undisplaced portion 1 a, 1 b (because the final depth of the depression D2 is less than the thickness T1 of the semiconductive layer in this example) the embossing has still produced an insulative feature 10, interrupting current flow in the undisplaced semiconductive layer at least by virtue of the cracks or other discontinuities C formed by the initial full displacement of the portion 11 out of the layer 1.

Moving on to Fig. 31e, this shows yet another step subsequent to those shown in Figs. 31a and 31b, this time where the compressible material 2 has been selected so as to be only slightly resilient after removal of the embossing tool 4. In other words, the material 2 and the degree of depression by the embossing tool 4 has been chosen such that the deformation of the portion of compressible material under selected portion 11 is substantially irreversible. Thus, when the embossing force is removed, the compressed portion makes only a small return towards its original shape, leaving portion 11 permanently displaced a distance D2 below the upper surface of the semiconductive layer, where D2 is greater than T1. An advantage of forming such a permanent displacement is that the insulative properties of the resultant insulative feature 10 can be improved, in as much as the insulative feature 10 forms a more complete barrier or interruption to current flow in the semiconductive layer 1.

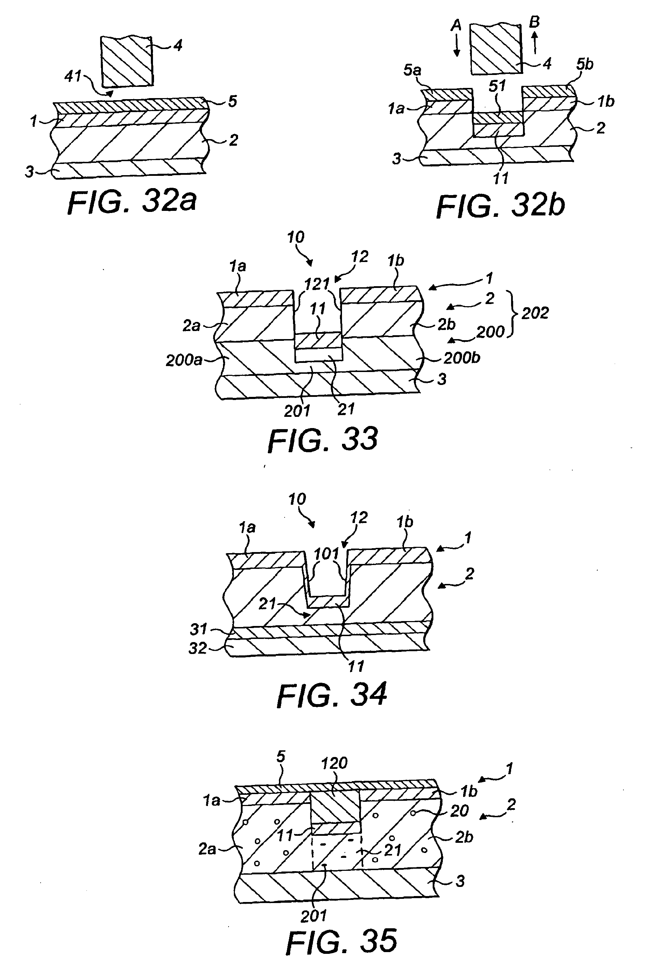

Referring now to Figs. 32a and 32b, in another method embodying the invention the embossing tool 4 does not make contact directly with the layer of semiconductive material 1. Instead, an additional layer of insulative material 5 is provided over the semiconductive layer, which is supported by the compressible layer 2 and then the substantially incompressible backing layer 3. The embossing tool 4 is then moved in the direction shown generally by arrow A so as to drive selected portions 11 of semiconductive material, and corresponding portions 51 of the insulative layer, down towards the support layer 3, compressing compressible material beneath. Advantageously, the insulative material 5 covering the semiconductor layer 1 can be selected for its anti-adhesion properties, that is it can be selected so that it is reluctant to adhere to the embossing surface 41 of the embossing tool 4. The covering layer 5 may thus be selected to provide a low-adhesion, or non-stick "barrier" between the embossing tool and the semiconductive material 11, for use when the semiconductive material itself may otherwise have tended to stick to the embossing surface 41 and so hinder the formation of well defined insulative features during the embossing process. Although in the figures the insulative material 5 and layer of semiconductive material 1 are both shown to be substantially non-compressible, in alternative embodiments the semiconductive layer 1 may be compressible, at least to a certain degree, as may be any covering or capping layer 5.

Moving on to Fig. 33, this shows part of an electronic device embodying the invention. The figure shows an insulative feature 10 formed in the device substrate which is a multi-layer structure comprising a layer of semiconductive material 1 supported by a multi-layer compressible structure 202, which is itself supported on a substantially non-compressible backing layer or base layer 3. The multi-layer compressible structure 202 comprises an upper layer 2 of compressible material and a lower layer 200 of compressible material. Thus, in this example each of the component layers of structure 202 are themselves compressible, and they may compress to differing degrees or the same degree under the action of a compressive force. The insulative feature 10 formed in the device substrate comprises a trench 12 having side walls which comprise exposed portions of the upper layer 2 of compressible material (which in this example is insulative), and the base of the trench 12 is defined by a portion 11 of semiconductive material that has been displaced from the layer 1 so as to be completely electrically separated from undisplaced portions 1 a, 1 b on either side of the trench 12. Beneath the displaced portion 11 are located compressed portions 21 and 201 of the upper and lower compressible layers respectively.

Referring now to Fig. 34, this shows part of a device substrate part way through the manufacture of an electronic device from the substrate. The device substrate comprises a layer of semiconductive material 1 supported by a layer of compressible material 2, itself formed over a multilayer backing structure comprising a first support layer 31 and a second support layer 32. An insulative feature 10 has been formed by displacing a portion 11 of the semi conductive layer down into the compressible layer 2, compressing a portion 21 beneath it. However, the method has been such that portions of semiconductive material 101 coat the side walls of the trench 12 formed by this displacement. These portions 101 provide some electrical conductivity, albeit reduced, across the insulative feature 10. In certain embodiments, the reduction in conductivity formed by producing these thinner regions 101 on the side walls of the trench 12 may be sufficient, depending on the required function of the insulative feature in the eventual device. However, in alternative embodiments, the insulative feature 10 may undergo further processing to remove these portions 101 such that the displaced portion 11 is completely electrically isolated from undisplaced portions 1 a and 1b. In the example shown in Fig. 34, the compressible material 2 is not porous, although it is of course compressible so that its density under the displaced portion 11 (i.e. the density of the compressed portion 21) is greater than under the undisplaced portions.

Referring now to Fig. 35, this shows part of an electronic device embodying the invention and manufactured using a method also embodying the invention. The device comprises a layer of semiconductive material 1 supported by a layer of compressible material 2, which in this example is porous. A backing layer 3 supports the compressible layer 2. An insulative feature interrupts the semiconductive layer, separating portions 1a and 1b on either side of the feature, that feature comprising a trench filled with insulative material 120 and having a base defined by a portion 11 of semiconductive material that has been displaced from the layer 1. Beneath the insulative feature a portion 21 of the compressible layer has a reduced porosity compared with that of relatively uncompressed portions 2a and 2b under the undisplaced portions of the semiconductive layer 1. An insulative layer 5 has been formed over the semiconductive layer and filled trench.

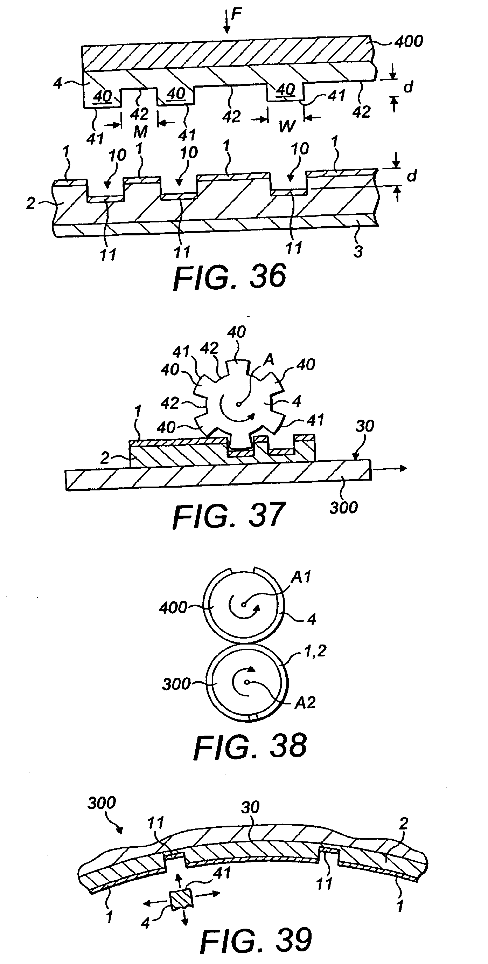

Referring now to Fig. 36, embossing apparatus used in another method embodying the invention comprises an embossing tool 4 which comprises a plurality of embossing features 40, each embossing feature comprising a respective embossing surface 41 raised (i.e. protruding) a distance d from a base surface 42. In this example the embossing tool 4 is supported on an embossing support 400 such that the base surface 42 is substantially planar, and is substantially parallel to the layer of semiconductive material 1 in a device substrate. In order to pattern the semiconductive layer 1 a force F is applied to the support 400 so as to urge the embossing features 40 into the multi-layer device substrate, such that each embossing surface 41 drives a corresponding portion 11 of the semiconductive material from the layer 1 down into the compressible layer 2, towards the backing layer 3. Thus, the pattern of insulative features 10 produced in the layer of semiconductive material 1 corresponds to the pattern of embossing features 40 on the embossing tool 4. In this example, each of the embossing features have substantially the same width W, that width corresponding to the width of each embossing surface 41. The minimum separation between adjacent insulative features 40 in this example is denoted by M, and M is substantially equal to W.

Referring now to Fig. 37, this illustrates the patterning of a layer of semiconductive material with insulative features in another method embodying the invention. Here the embossing tool 4 is generally cylindrical, arranged to rotate about a longitudinal axis A, and having a generally cylindrical base surface 42 from which each insulative feature 40 protrudes, defining an outer embossing surface 41. A device substrate comprising a semiconductive layer 1 supported by a layer of compressible material 4 is supported on a flat support surface 30 of a moveable support or bed 300. This bed 300 is translated in the direction shown by the straight arrow in the figure as the embossing tool is rotated about axis A, thereby allowing each embossing feature 40 to produce its corresponding insulative feature in the device substrate as that substrate passes beneath the roller. Such apparatus and method is suitable for the rapid and large scale patterning of substrates to form devices and circuits, as will be readily appreciated.

Moving on to Fig. 38, in this example the embossing tool 4 is substantially flexible, and has been mounted on a cylindrical support roller 400 arranged to rotate about a first longitudinal axis A1. Similarly, the device substrate to be patterned, and comprising the layer of semiconductive material and compressible layer 2 has been mounted on a support roller 300 arranged to rotate about axis A2 which is parallel to axis A1. The size of the embossing features on the tool 4 is so small that they have not been represented on the figure. Similarly, the structure of the device substrate is now shown on the figure to maintain its clarity. However, it will be appreciated that a wide variety of forms for the device substrate may be supported on the roller 300 and patterned in this way. For example the layer of semiconductive material may be just one layer of a multi-layer semiconductive structure, the compressible layer may be a layer of a multi-layer compressible structure, and the device substrate may additionally comprise one or more backing, support, or base layers and one or more capping, covering or overlying layers above the semiconductive material.

Moving on to Fig. 39, this shows yet another arrangement of components in a method embodying the invention. Here the device substrate comprising the semiconductive layer 1 and compressible layer 2 is substantially flexible, and has been supported on the concave supporting surface 30 of a support member 300. An embossing tool 4 having an embossing surface 41 has been moved with respect to the device substrate and support surface 30 so as to create indentations in the semiconductive layer, thereby producing insulative features. Each indentation comprises a respective portion 11 of semiconductive material pressed into the compressible layer by the tool 4. In contrast to embodiments where an extensive embossing tool comprising a plurality of insulative features is used to pattern the semiconductive layer, in this example the embossing surface is relatively small, and a large pattern of insulative features is produced by translating the embossing tool 4 to different positions above the semiconductive layer before pressing to displace portions 11.

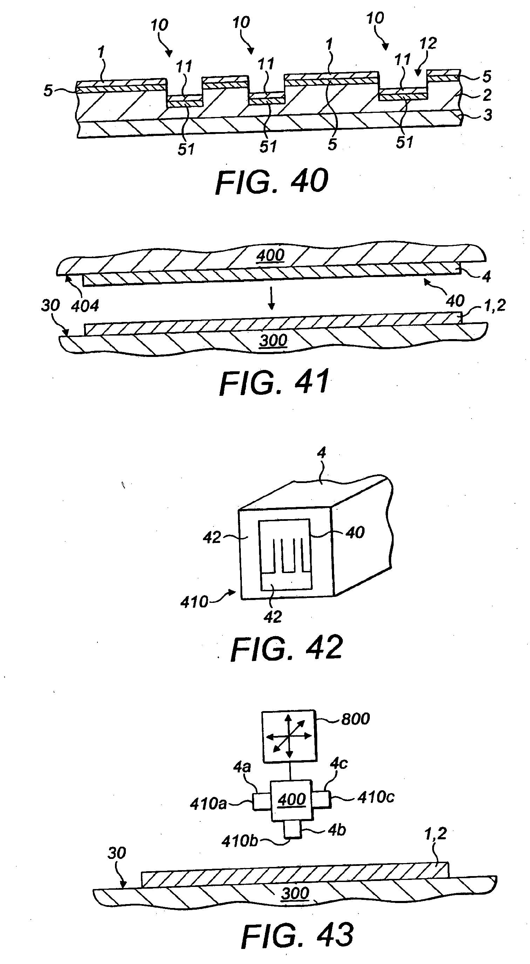

Referring now to Fig. 40, this shows part of an electronic device embodying the invention. The device comprises a semiconductive layer 1 patterned by a plurality of insulative features 10. The semiconductive layer is supported by a layer of compressible material 2, but not directly; instead there is a layer of insulative material 5 arranged between the semiconductive 1 and compressible 2 layers. The compressible layer 2 is itself supported by a backing support or substrate 3. Each insulative feature 10 comprising a trench 12 formed by displacing a respective portion 11 of semiconductive material and a corresponding portion 51 of separating layer material down towards the support 3, thereby compressing compressible material 2 underneath. Advantageously, by having this intermediate layer 5 between the semiconductive layer 1 and compressible layer 2, the process engineer is provided with more options to overcome material incompatibility problems. For example, use of the intermediate layer 5 may enable the device to incorporate semiconductive material 1 which would not adhere well directly to the compressible material 2. The compressible material 5 may be selected to be a material to which both the semiconductive layer 1 and compressible material 2 adhere well to.

Referring now to Fig. 41, this shows apparatus involved in the manufacture of an electronic circuit embodying the invention. Here, a relatively large and extensive device substrate comprising at least one layer of semiconductive material and at least one layer of compressible material 2 supporting the semiconductive layer is flexible but supported on the flat support surface 30 of a rigid support member or table 300. Positioned with respect to the device substrate is an extensive embossing tool 4 in the form of a stamp or shim having a facing surface provided with a plurality of embossing features on the nanometre scale. These features are too small to be shown in detail on the figure, but their location is indicated generally by arrow 40. The stamp or shim is itself flexible, and is supported on a substantially flat support surface 404 of a support member or assembly 400. In order to pattern the device substrate the shim or stamp is forced into contact with the device substrate, so that each embossing feature penetrates the surface to a depth which brings the base surface of the embossing tool into contact with the "upper" surface of the device substrate (be that a surface of a semiconductive layer, or some other layer provided between the semiconductive layer and the shim). The force with which the shim is pressed against the device substrate may be controlled, as may be the length of time for which the two are in contact. The shim is then withdrawn. In this way, the pattern of embossing features on the shim is transferred to the layer of semiconductive material in a single step. Thus, in embodiments where the shim comprises features defining one or more insulative regions, a plurality of devices, or indeed part or all of one or more complete electronic circuits, these features can all be transferred to the semiconductive layer in a single embossing or stamping step. In certain embodiments, such a single step can be used to pattern an entire electronic circuit in the semiconductive layer of the device substrate.

Referring now to Fig. 42, this shows an embossing tool which may also be described as an embossing head, and which may be used in methods embodying the invention. The embossing head 4 has an end surface 410 comprising a base surface 42 and a plurality of embossing features 40 raised above (i.e. protruding from) the base surface 42. In this example the embossing features 40 are arranged in a pattern to define a complete electronic device such that when the embossing tool is used to pattern a semiconductive layer supported by a compressible layer, the resultant pattern of insulative features in the semiconductive layer enables the patterned semiconductive layer to function as the device without requiring further processing. In this particular example, the pattern of embossing features 40 is arranged to define a diode in a semiconductive layer, that diode comprising a pair of elongate semiconductive channels defined by an asymmetrical arrangement of insulative features, each channel connecting a first, undisplaced portion of semiconductive material to a second undisplaced portion. It will be appreciated that although the embossing head of Fig. 13 is patterned so as to be able to produce a diode in a single stamping operation on a semiconductive substrate, embodiments of the invention are able to use differently patterned embossing heads, to produce other devices in a single stamping operation as required. Referring now to Fig. 43, this is a highly schematic representation of embossing apparatus embodying the invention and which may be used in methods embodying the invention to produce electronic devices and circuits themselves embodying the invention. The apparatus comprises a plurality of embossing heads 4a, 4b, 4c each having a respective end surface 410a, b, c provided with a pattern of embossing features suitable for defining a complete, single respective device in the semiconductive layer of a device substrate in a single stamping operation. The embossing heads 4a, b, c are all supported on a head support 400 which is operable to position a selected one of the heads over a device substrate to be processed. In other words, the apparatus is operable to bring different embossing heads into position over the device substrate in order to stamp patterns defining different devices into the semiconductive layer at different positions on the device substrate and so build up at least part of an electronic circuit, if desired. Although not shown in the figure, in certain embodiments the embossing head support 400 may also be adapted to support one or more additional heads suitable for use in embossing features in the device substrate to define connections between devices, between devices and supply rails, between devices and terminals, or indeed between any circuit components as required in order to produce a fully functioning circuit in the single layer of semiconducting material. The head support 400 in this example is rotatable to bring different heads into position over the substrate. The head support 400 is itself connected to a support structure 800 which is able to translate the head support with respect to the device substrate 1, 2 supported on the support surface 30 of a table 300 in any one of three dimensions. Thus, the support assembly 800 can be operated to bring a selected embossing head 4a, b, c into position over any selected portion of the device substrate, and additionally may be operated so as to stamp the device substrate using the selected embossing head. It will be appreciated that the apparatus of Fig. 43 represents an alternative way of producing a plurality of components, or indeed an electronic circuit on an extensive substrate, as compared to the technique illustrated in Fig. 41 where the embossing tool is itself patterned to define the whole array of devices and/or their interconnections.

It will be appreciated that although Fig. 42 and Fig. 43 show embossing heads each provided with embossing features defining just a single device, in alternative embodiments a single embossing head may be provided with embossing features to define a plurality of devices and/or defining complete electronic circuits.

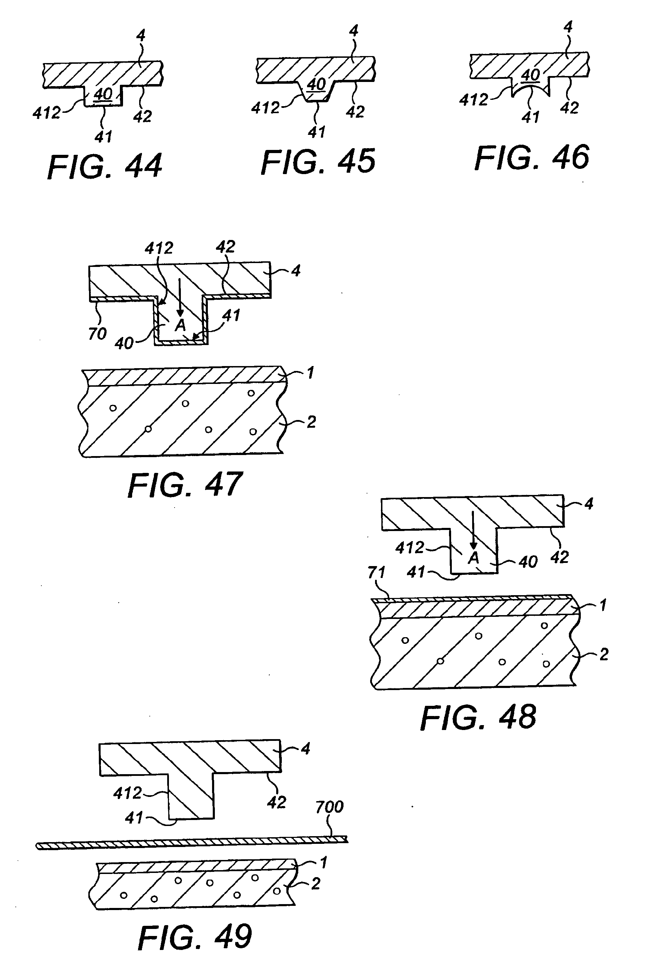

In certain embodiments, one or more (or indeed all) of the embossing features provided on the embossing tool may be substantially rectangular in cross section, having a flat end, embossing surface 41 connected to the base surface 42 by side surfaces 412 substantially perpendicular to the base surface 42. Such an arrangement is shown in Fig. 44. However, different embodiments may employ one or more embossing features having different shapes. For example, one such alternative shape is shown in Fig. 45, wherein the embossing surface 41 is substantially flat, but is connected to the base surface 42 by sloping side walls 412 such that the embossing feature 40 tapers inwardly from its base towards its tip.

Fig. 46 shows another alternative shape of embossing feature which may be used in embodiments of the invention. Here the embossing surface 41 is concave, connected by side walls 412 which are again substantially perpendicular to the base surface 42.

Referring now to Fig. 47, this illustrates part of another method of manufacturing an electronic device embodying the invention. Here, before the embossing tool 4 is used to produce an insulative feature in the device substrate comprising the semiconductive layer 1 and the compressible layer 2, the embossing tool 4 is coated with a layer of material 70. This material coats the embossing surface 41, the base surface 42, and the side walls of each embossing feature 40 in this example. This coating 70 may be a material selected to prevent or reduce/inhibit adhesion between the embossing tool and the semiconductive material 1. Coating the embossing tool in this way before using it to pattern the device substrate enables better defined insulative features to be formed, thereby improving the reliability of the process in producing working devices.

Fig. 48 illustrates an alternative technique in which rather than coating the embossing tool 4 with a non-stick material, the semiconductive layer 1 itself is provided with a non-stick or adhesion reducing coating or layer 71 prior to embossing.

Fig. 49 represents yet another technique for preventing or reducing adhesion between the embossing tool 4 and the device substrate (and in particular the semi-conductive layer 1). Here, a separating film or membrane 700 is provided between the embossing tool 4 and device substrate such that during the subsequent stamping operation, the semiconductive layer 1 is embossed through (i.e. via) the film or membrane 700. Depending on the materials being used and device requirements the film or membrane 700 may be left in place on the patterned device substrate, or may be removed.

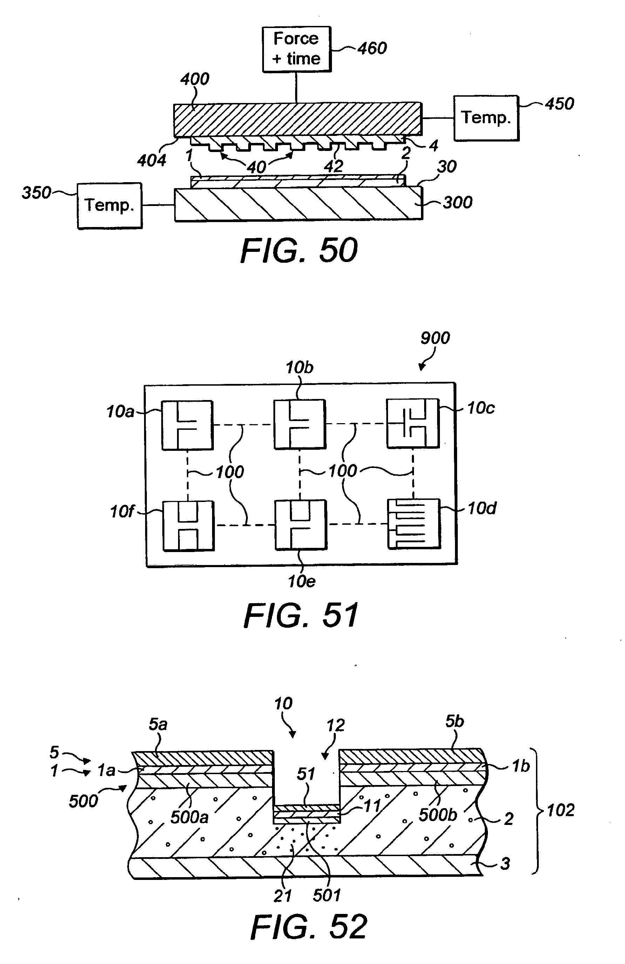

Referring now to Fig. 50, this shows in highly schematic form embossing apparatus embodying the invention and suitable for carrying out methods embodying the invention. Here, the device substrate comprising a semiconductive layer 1 supported by a compressible layer 2 is itself supported on the surface 30 of a rigid support 300 connected to a support temperature controller 350. This controller 350 is adapted to control a temperature of the support 300 and in turn the temperature of the semiconductive and compressible layers 1, 2. The controller 350 is operable to set a desired temperature of the support 300 before commencing an embossing operation. In certain embodiments the temperature controller 350 is further arranged to control the temperature of the support 300 while the embossing process is taking place (i.e. while the embossing tool 4 is in contact with the device substrate). The controller 350 can be used to alter the temperature of the support 300 during the embossing process, and indeed change the temperature of the support 300 during embossing, before the embossing tool 4 is separate from the device substrate. The apparatus also comprises an embossing tool 4 provided with a pattern of embossing features 40 raised above a base surface 42. The embossing tool (stamp or shim) is rigidly supported on the surface 404 of a stamp support 400. This support 400 is connected to a temperature controller 450 which, like the temperature controller 350 for the support 300 is adapted to set, control and optionally adjust a temperature of the stamp support 400 before and/or during the embossing process, and indeed to control (e.g. maintain constant, or change or pulse at a particular frequency or set of frequencies) a temperature of the shim support 400, and thereby the temperature of the shim (embossing tool) 4 itself before the shim is withdrawn from the device substrate to leave the desired pattern imprinted thereon. The apparatus additionally comprises a force and time control means 460 connected to the shim support 400 and operable to control both the force with which the embossing tool 4 is pressed against the device substrate and the time for which that force is applied (in other words, the controller 460 is operable to determine the duration of the imprinting process). It will be appreciated that the apparatus of Fig. 50 provides a wide range of operational flexibility, and various parameters of the embossing process can be controlled to improve or optimise results. These parameters include the embossing force (which may be held constant, or modulated in some way, for example by pulsing the applied force at a particular frequency or set of frequencies), the duration of the embossing process, the temperature of the embossing tool (before and during contact with the device substrate, and before withdrawal) and the temperature of the device substrate support 300 (before and during the imprinting process, and before withdrawal of the imprinting tool). The apparatus of Fig. 50 can therefore be used to implement methods embodying the invention and described elsewhere in this specification.

Referring now to Fig. 51, this is a highly schematic representation of an electronic circuit 900 embodying the invention, that circuit comprising a plurality of electronic devices and their interconnections formed in a single layer of semiconductive material. Each device is defined by a corresponding pattern or array of insulative features 10a-10d formed in the layer of semiconductive material, which is supported, either directly or indirectly by a layer of compressible material. In the highly schematic illustrated example, insulative feature patterns 10a and 10b each define respective diodes (in other words, each pattern defines a portion of the semiconductive substrate which functions as a diode). Insulative feature pattern 10c defines a logic OR gate. Insulative feature pattern 10d defines an AND gate. Insulative feature pattern 10e defined a general diode structure but with an additional side gate so as to provide a diode with a tunable threshold. Insulative feature pattern 10f defines a field effect transistor. The insulative feature patterns may comprise insulative regions, formed using methods embodying the invention. Additional insulative regions may be incorporated to provide isolation between devices, and/or to isolate the circuit from another portion of the active layer.

It will be appreciated that the circuit 900 shown in Fig. 51 may conveniently be manufactured using a single patterning step in which the semiconductive layer is patterned using an embossing tool (in the form of a stamp, shim or other arrangement) having a suitable pattern of embossing features formed thereon in order to define the full electronic circuit (i.e. all devices and their interconnections in a single embossing step).

Referring now to Fig. 52, an electronic device embodying the invention comprises a multi-layer device substrate 102. This substrate 102 comprises a layer 1 of semiconductive material, a first (upper) layer 5 of insulative material formed over the semiconductive layer 1, a second (lower) layer 500 of insulative material formed on the other side of the semiconductive layer 1, a layer or body of compressible material 2 supporting the insulative and semiconductive layers 1, 5, 500, and a substantially non-compressible backing or support layer 3 supporting the compressible layer 2. In this example the layer of semiconductive material 1 is relatively thin and relatively non-compressible. In addition to the compressible layer 2, each of the insulative layers 5, 500 are at least partially compressible. An insulative feature 10 has been formed in the device substrate to completely interrupt the layer of semiconductive material 1, electrically isolating an undisplaced portion 1 a from another undisplaced portion 1 b in the direction across the feature 10. Insulative feature 10 has been formed by displacing respective portions 51, 11, 501 of the upper insulative layer, semiconductive layer, and lower insulative layer respectively. A corresponding portion 21 of the compressible material has been compressed beneath these displaced portions, i.e. between the displaced portions and the backing layer 3. In displacing these portions, the portion 51 of the upper insulative layer and portion 501 of the lower insulative layer on either side of the displaced portion of semiconductive layer have themselves been compressed and lie at the base of the trench 12 formed in the surface of the overall device substrate 102.

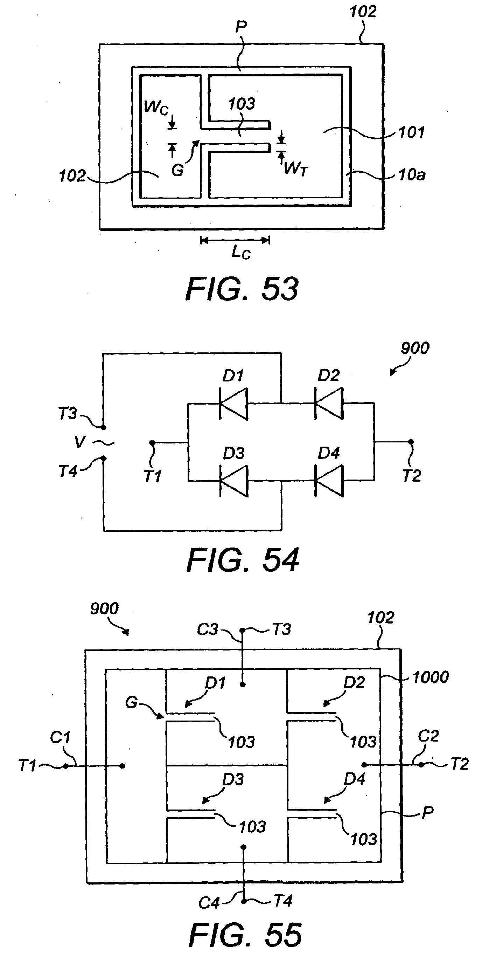

Moving on to Fig. 53, this shows a device (manufactured using techniques which may be utilised in embodiments of the invention), in which a pattern 10a of insulative features (in this example insulative trenches) have been formed to interrupt the semi-conductive layer of a device substrate 102 to define a self-switching diode. The insulative features comprise a plurality of lines (or straight trenches) which are connected to define an insulative perimeter P, insulative lines extending inwardly from opposing sides of the perimeter P to define a gap G, and further insulative lines extending from the ends of the opposing lines defining the gap G towards a first portion 101 of the semiconductive layer. The insulative features define an elongate channel 103 (of length L_{c}, and width W_{c}) which provides a charge carrier flow path in the semiconductive layer from the first area 101 to a second area 102. In this embodiment the elongate channel 103 is dimensioned and arranged such that the parameters of the charge carrier flow path are dependent on a potential difference applied between the first and second areas 101, 102. The insulative features are arranged such that the device exhibits diode-like characteristics in response to application of a voltage across the first and second areas 101, 102. Further details on the operation of this device, and mechanisms contributing to this diode-like behaviour will be appreciated from WO 02/086973 A2, for example. In this example, all of the insulative trenches forming the pattern of insulative features have the same width Wₜ. In certain embodiments, Wₜ may be in the range 30-300nm. Similarly, W_{c} may be in the range 10-400nm. Also, L_{c} may be in the range 100-3000nm.

It will be appreciated that the pattern of insulative features 10a shown in Fig. 53 defines a single electronic device, namely a single diode. In other embodiments of the invention, a plurality of electronic devices may be formed in a single common substrate by patterning with insulative features, and interconnections may also be provided to form at least part of an electronic circuit.

Fig. 54 shows a rectifier circuit, and Fig. 55 shows that circuit formed in an embodiment of the invention. Fig. 54 shows the well-known arrangement of four diodes D1-D4 which can produce a rectified output at terminals T1 and T2 when an alternating voltage V is applied between terminals T3 and T4. Fig. 55 shows the rectifier circuit 900 as provided by an embodiment of the invention. A device substrate 102 comprising a layer of semiconductive material has been patterned with a pattern or array 1000 of insulative features (which may comprise trenches) to define insulative regions and define the four diodes D1-D4 and the interconnections between them. Each diode has the general structure of the diode shown in Fig. 53 and described above, i.e. it comprises a narrow, elongate channel defined by the insulative features to give the self-switching behaviour. In other words, the asymmetric arrangement of the insulative features with respect to the gap between the features separating the nominal first area of semiconductive material on one side of the gap from the second area of semiconductive material on the other side of the gap is such that when a potential is applied between those two areas the potential in the first area affects the conductivity of the conductive channel through the gap via the insulative features defining it. This influence is asymmetric. With the potential difference in one sense, the conductivity of elongate channel can be reduced, even to zero, as depletion regions inside the channel inhibit or prevent charge carrier flow. In the opposite polarity, charge flow is permitted.

Still referring to Fig. 55, it will be appreciated that the arrangement of insulative features 1000, in addition to defining the four diodes D1-D4, defines portions of the layer of semiconductive material which provide interconnections between the devices. The circuit 900 of Fig. 55 comprises some additional connections C1-C4 (that is in addition to those provided by portions of the layer of semiconductive material itself) which provide connections between external terminals T1-T4 and respective portions of the device semiconductive layer.

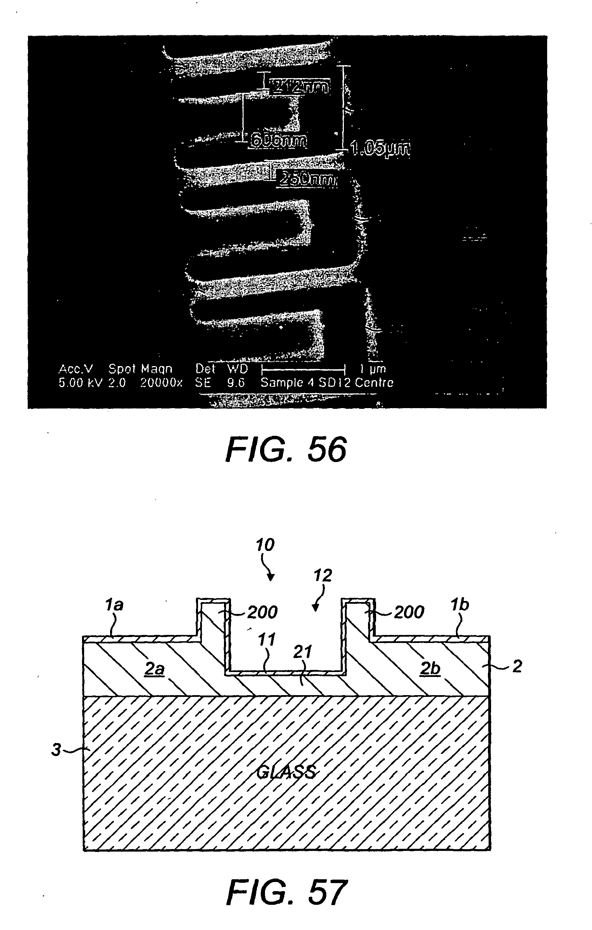

Referring now to Fig. 56, this is a microscope image of part of another electronic device embodying the invention. The figure shows a plurality of insulative features 10 formed in a device substrate. The insulative features 10 have been produced in parallel (i.e. at the same time) by an embossing process in which respective portions of the upper layer of semiconductive material in this example have been pressed or driven down into an underlying compressible layer so as to separate those portions from the undisplaced upper portion of semiconductive material. In effect, each insulative feature 10 has formed a trench in the semiconductive layer to interrupt that layer in the desired pattern, the displaced portions of semiconductive material being separated from the undisplaced layer, lying as they do at the bottom of each trench. The embossing tool has been patterned such that the insulative features 10 define a parallel array of diodes, each diode comprising a respective elongate channel 103 defined between adjacent insulative trenches and connecting a first portion or area 101 of the layer of semiconductive material to a second area or portion 102. The dimensions of certain features are indicated on the figure. For example, each channel 103 has an approximate width of 250 nanometres, and the width of the insulative trenches defining the sides of the channels are approximately 212 nanometres in this example. The device substrate in this example comprises an upper layer of semiconductive material P3HT. This has been formed on top of a compressible layer of PMMA, itself supported on a substantially non-compressible layer of SiO₂. The embossing tool used to produce the features in Fig. 56 was provided with a corresponding pattern of embossing features, and was urged into contact with the upper surface of the layer of P3HT with a force of 1.5kN, at a temperature of 85°C. It will be appreciated from the figure that the insulative features 10 are well defined, and tests confirm that the resultant device exhibited clear diode-like characteristics. The device comprises an insulative region surrounding the array of diodes, but that region is outside the portion of the active layer shown in the figure.

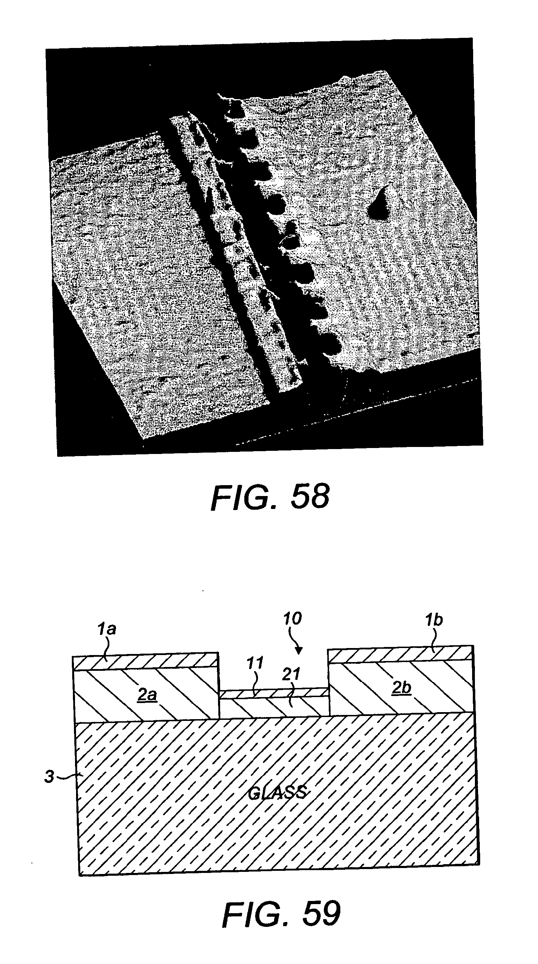

Referring now to Fig. 57, this is a schematic representation of an insulative feature formed in another embodiment of the invention. Here, the semiconductive layer is a layer or organic semiconductive material, supported by a compressible layer of PMMA, itself supported on a glass support substrate. An embossing technique has been used to displace a portion 11 of the semiconductive layer down into the compressible layer 2 to form a trench. In this example, electrical separation between the displaced portion 11 and undisplaced portions 1 a, 1 b is not complete as a thin layer of semiconductive material lines the side walls of the trench 12, and indeed the embossing process has resulted in peaks or raised areas of compressible material 200, themselves coated with a layer of semiconductive material, being formed on either side of the trench. These features can be seen in the microscope image of part of another embodiment shown in Fig. 58. It will be appreciated that for certain applications, the partially insulative feature 10 shown in Fig. 57 may be adequate, but in other embodiments in which complete electrical isolation of the displaced portion 11 from the undisplaced portions 1 a, 1 b is required then further processing steps are needed. Such processing steps can include one or more steps to remove the layer of semiconductive material from the side walls of the trench 12 (and examples of such techniques include etching, for example). It will be appreciated that the distortion of the layer of compressible material 2 as a result of the embossing process shown in Fig. 27 may be dependent upon the particular compressible material being used and also the temperature and force at which the embossing process is being carried out. For example, in order to reduce or completely avoid the formation of protrusions 200, the embossing may be carried out at reduced temperature and/or the thickness of 2a increased. In certain embodiments, the device substrate may be cooled to a predetermined temperature before embossing, such that the embossing process may then result in the formation of an insulative feature closer to the ideal form shown in Fig. 59.

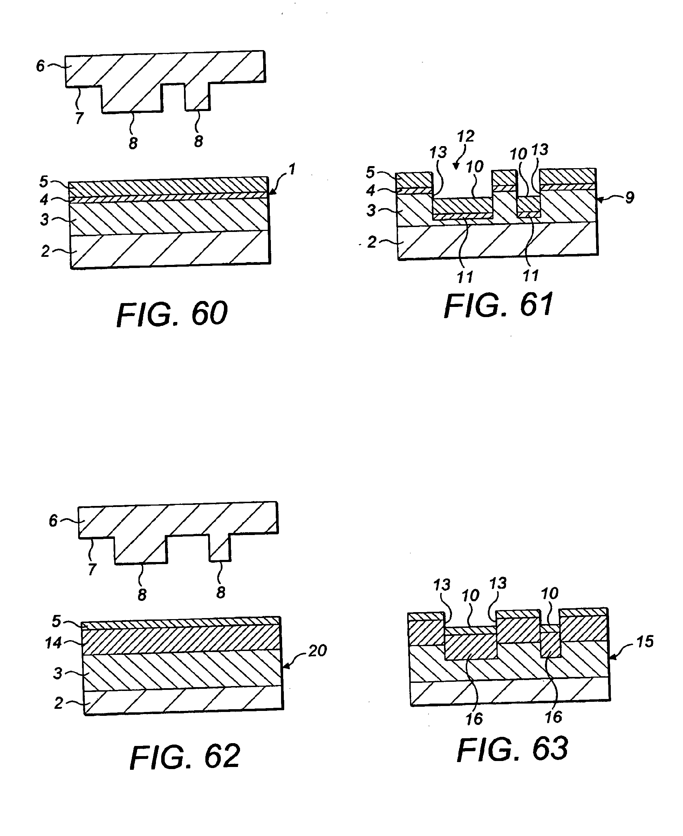

Further embodiments will now be described with reference to Figs. 60-69.

Referring to the embodiment as shown in figure 60, the pre-form 1, consists of a carrier substrate of PET (polyethylene terepthalate) 2 upon which is a yielding layer 3 of polymethylmethacrylate (100nm is spin-coated from a 0.3%wt anisole solution "mw 950,000). The yielding layer 3 is also non-conductive. A monolayer of self-assembled material 4 (octadecyltrichlorosilane (OTS) of approx. 1 nm thickness is dip-coated from 1%wt solution in cyclohexane or n-methylpentane (NMP) at 21°C or less - OTS can also be spin-coated from NMP or vapour-deposited) is located on the yielding layer 3 with the active layer 5 (20nm of poly-3-hexylthiophene obtained from Sigma-Aldrich is spin-coated from a 1%wt trichlorobenzene solution) located on the layer 4.

The stamp 6 has a base area 7 and raised embossing areas 8.

In a method embodying the invention, the stamp 6 is pressed into the active layer 5 of the pre-form 1 in order to form the device template 9 as shown in Fig. 61. The stamp is pressed into the template until the base area 7 comes into contact with the surface of the active layer 5. The stamp is subsequently removed.

Displaced portions 10 of active layer 5 are punched by the raised embossing areas 8 of the stamp 6 into the yielding layer 3. Carried with them are displaced portions 11 of the self-assembled polymer layer 4. The yielding layer 3 beneath the displaced portions 10, 11 is permanently compacted to allow the displacement. Apertures 12 are thus formed in the active layer 5. The gap 13 ensures that the displaced portions 10 of active layer 5 are not in conductive contact with the undisplaced active layer 5.

Referring to the embodiment as shown in Fig. 62, the pre-form 20, consists of a carrier substrate of PET 2 upon which is a yielding layer 3 of polymethylmethacrylate (100nm is spin-coated from a 0.3%wt anisole solution "mw 950,000). A layer of non-conductive material 14 (150nm of polyvinylacetate is spin-coated from 1%wt aqueous solution) is located on the yielding layer 3 with the active layer 5 (30nm of "polyquaterthiophene" PQT12 is spin-coated from 1%wt trichlorobenzene) located on the non-conductive layer 14.

As for the above method embodying the invention, the stamp 6 is pressed into the active layer 5 of pre-form 1 in order to form the device template 9 as shown in Fig. 61. The base area 7 is not brought into contact with the surface of the active layer 5, but is stopped by a control mechanism (not shown) after penetrating a predetermined distance into the template. The stamp is then removed.

Displaced portions 10 of active layer 5 are punched by the raised areas of the stamp 6 into the non-conducting layer 14. Carried with them are displaced portions 16 of the non-conductive layer 14, as shown in Fig. 63. The portion of yielding layer 3 beneath the displaced portions 10, 16 is permanently displaced. Apertures 12 are thus formed in the active layer 5. The gap 13 ensures that the displaced portions 10 of active layer 5 are not in conductive contact with the undisplaced active layer 5.

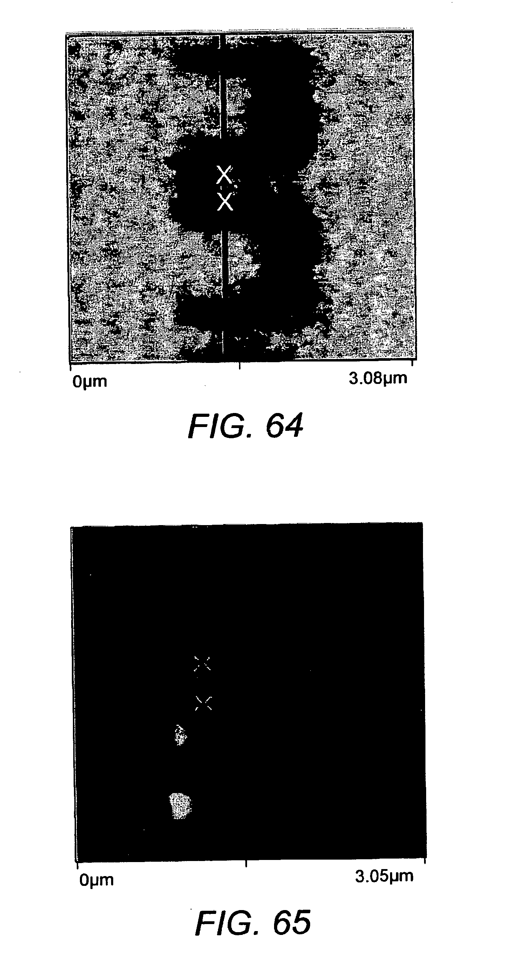

Referring now to Fig. 64, this shows an image (by atomic force microscopy) of a stamp 6 for use in the embodiments of Figs. 31A and 31B. The stamp is of nickel. The "]" shapes correspond to the raised embossing area 7, while the surrounding surface is the base area 8.

Fig. 65 shows an atomic force micrograph of a device prepared using the stamp 6, where the "]" shapes are disturbed active layer 10 and the rest of the active layer shown 5 remains undisturbed, defining the features of a planar nanoelectronic diode between the two "x" marks

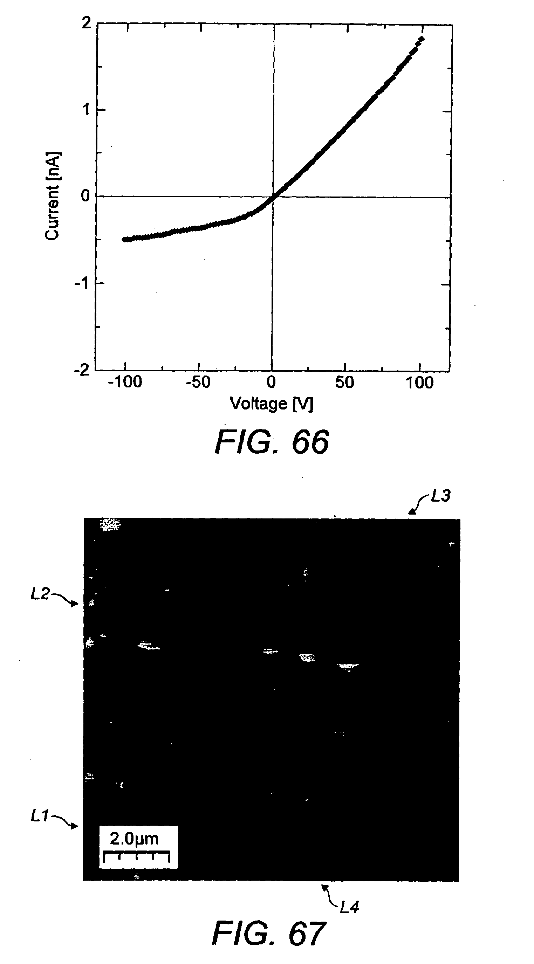

Referring now to Fig. 66, this shows a current/voltage plot obtained for the device of Fig. 65, obtained after electrical contacts have been applied to the active layer 5 of the device. An insulating region is formed by the "]" areas of disturbed active layer 10. The elongate channel between the two "x" marks is formed with the conductivity of the elongate channel dependent upon the potential difference across the "]" shaped areas of disturbed active layer 10 (i.e. the device functions as a diode).

It will be appreciated that numerous modifications to the above described embodiments may be made without departing from the scope of the invention as defined in the appended claims. For example, a protective layer may be situated on the template over the active layer.

The described and illustrated embodiments are to be considered as illustrative and not restrictive in character, it being understood that only the preferred embodiments have been shown and described and that all changes and modifications that come within the scope of the inventions as defined in the claims are desired to be protected. It should be understood that while the use of words such as "preferable", "preferably", "preferred" or "more preferred" in the description suggest that a feature so described may be desirable, it may nevertheless not be necessary and embodiments lacking such a feature may be considered as within the scope of the invention as defined in the appended claims. In relation to the claims, it is intended that when words such as "a," "an," "at least one," or "at least one portion" are used to preface a feature there is no intention to limit the claim to only one such feature unless specifically stated to the contrary in the claim. When the language "at least a portion" and/or "a portion" is used the item can include a portion and/or the entire item unless specifically stated to the contrary.

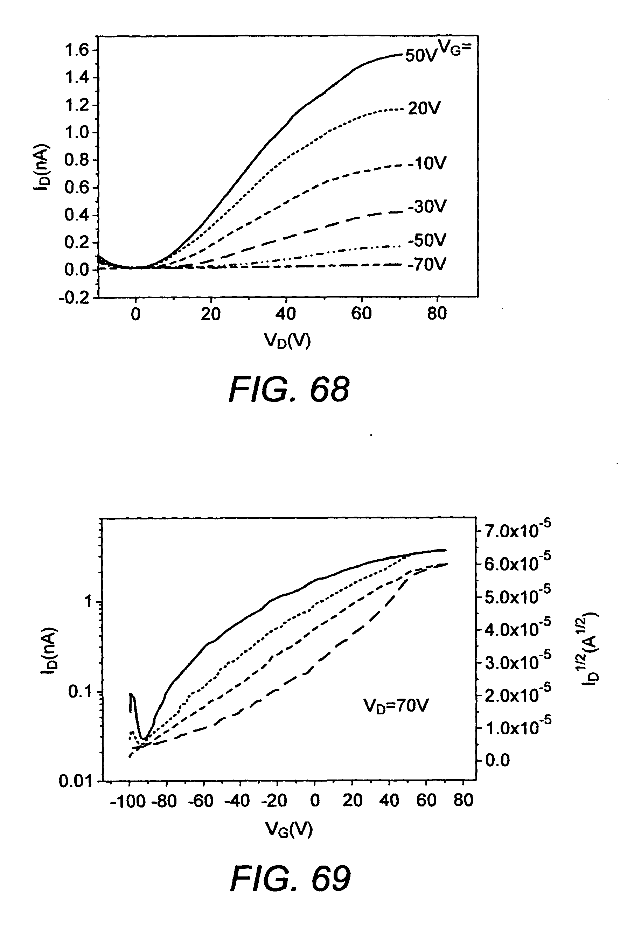

Referring now to Figs. 67 to 69, another embodiment of the invention is an embossed ZnO planar nano-transistor. Output and transfer characteristics of that embossed ZnO planar nano-transistor are shown in Figs. 68 and 69 respectively. The on/off ratio of the transistor is about 300. The transistor is formed from a substrate having the general structure: ZnO (10nm)/PMMA (1000nm)/SiO₂/Si. The method of manufacturing the transistor comprised: clamping (tool and substrate) at RT; heating up to 110°C; applying force 2000N which translates to a pressure 500 N/cm2; holding for 30mins; cooling down; de-molding (separating) at RT.

It will be appreciated that certain embodiments of the invention comprise a thermal embossing technique in which pressure and/or heat may be used to produce the desired pattern of insulative features in a semiconductive substrate or layer. In certain embodiments, the applied pressure, and/or the heating may be pulsed. Certain embodiments provide methods for manufacturing planar, nanoelectronic devices, in which an entire device or indeed an entire circuit or part of the circuit comprising a plurality of devices can be fabricated in a single step (i.e. a single patterning step).

In certain embodiments, a semiconductive layer can be patterned using a stamp or other embossing tool. Some such tools incorporate embossing features with a 1:1 aspect ratio (i.e. the height of the feature above the base surface is substantially equal to the minimum separation of the features). Such an arrangement may be used where the embossing tool is in the form of a flexible sheet or shim for use in a technique in which the embossing tool is supported on a roll for rapid manufacture of many devices in parallel, or indeed of large devices (i.e. devices occupying a large area of semiconductive material on a substrate).

Devices successfully manufactured using techniques embodying the invention have included electronic devices with ZnO as the active semiconductive material. Further devices have been successfully manufactured incorporating other semiconductive materials, including organic semiconductive materials such as P3HT.

It will be appreciated that an advantage of certain embodiments of the invention is that in a single step one can form a single pattern in a layer of semiconductive material to define an entire device, plurality of devices, part of an electronic circuit, or indeed an entire electronic circuit.

It will be appreciated that in addition to being able to produce insulative features in a semiconductive layer, techniques embodying the invention may also be used to emboss "optical" features (i.e. visible, optically detectable features) on the device substrate. Such features may be useful for security and/or alignment purposes for example.

In certain embodiments, an embossing tool may be used, that embossing tool taking the form of a stamp in which the pattern of embossing features has been "written" (i.e. patterned, or made) using an E-beam.

In certain embodiments, the compressible layer, which may also be described as a buffer layer, may comprise compressible, porous material, such as compressible, porous, solution-processible polymers.

In certain embodiments, the semiconductive material used is a polymer semiconductor. In general, layers of such materials are flexible, and the method of patterning such a layer by embossing into a compressible layer may comprise initially cooling the semi-conductor material to a predetermined temperature to reduce its flexibility and improve the definition of the insulative features formed. In other words, by setting the temperature of the semiconductive material to a suitable value before embossing, lining of the insulative trenches with semiconductive material can be reduced or avoided.

It will be appreciated that certain embodiments of the invention produce, in a single embossing step, one or more complete active electronic devices defined in a single layer of semiconductive material. In certain embodiments, the width of embossing features on an embossing tool can be less than 500 nanometres, less than 200 nanometres, or even less than 100 nanometres. The aspect ratio of the embossing features may be 1:1, 1:2, 1:3, or higher, such as 1:10. However, these aspect ratios are merely examples, and other embodiments may employ embossing tools having other aspect ratios for their insulative features.

In certain embodiments, the materials selected for the semiconductive layer and compressible layer are such that there is good adhesion between the two layers, and they can be provided in direct contact with one another. However, in certain other embodiments the semiconductive and compressible materials may not adhere well to each other (as can be the case when the semiconductive material is ZnO and the compressible material is PMMA). In such examples, the surface of the compressible layer may be processed or treated in some way (for example by plasma treatment) to improve the adhesion of the semiconductive layer when formed upon it.

In certain embodiments, a semiconductive layer of P3HT is provided (i.e. formed) on a compressible layer of PMMA. Such a combination may be formed by techniques using appropriate solutions; these materials are such that "orthogonal" solvents can be used (i.e. the solvent for one of the materials can be selected so as not to be a solvent for the other material). The advantages of this will be apparent to the person skilled in this field.

In certain embodiments, the semiconductive material provided as a layer and patterned with insulative features can be a metal oxide semiconductor (such as ZnO), a polymer semiconductor, or for example a small molecule organic semiconductive material.

In certain embodiments, the embossing tool may be formed from nickel, for example produced from a silicon master.

The embossing methods employed by embodiments of the invention in certain instances comprise punching through the active layer of semiconductive material, driving selected portions down into the compressible layer (which may also be described as a buffer or yielding layer). Thus, active material may be pushed or driven into the buffer layer, by displacing it from its initial position and plane.

Factors which may be adjusted in methods embodying the invention include: the temperature at which the embossing is performed (and there is further flexibility to set the temperatures of the embossing tool and device substrate to be embossed separately, and indeed to alter temperatures during the embossing process); the pressure applied between the embossing tool and the device substrate; the material selected for the various device substrate layers; the thicknesses of the various layers and the dimensions of the embossing features on any embossing tool; the hardness of the materials being used for the various layers; and the size of the features provided on any embossing tool. In certain embodiments, it is desirable to employ relatively brittle semiconductive material before the embossing process is performed. This can involve the selection of intrinsically brittle material for the semiconductive layer, or indeed can comprise setting process conditions such that the layer of semiconductive material is relative brittle when the embossing takes place. In certain embodiments, an embossing tool may become contaminated or otherwise coated by material from the device substrate during the embossing process. In order to reduce this, certain embodiments employ coating or otherwise treating the embossing tool before patterning the semiconductive layer to reduce adhesion between the device substrate and the tool.

In certain embodiments, the layer of insulative compressible material may be PMMA. In certain examples, this may be selected to have high molecular weight, or indeed low molecular weight, giving different characteristics under compression. In other words, materials having different initial densities may be selected for use as the compressible material, giving a further adjustable parameter in the process.

In certain embodiments, a scratching or etching technique may be employed to further enhance the insulative features after embossing, for example to clean out any semiconductive material remaining in the formed trenches. In other embodiments, such further processing may not be required.

In certain embodiments, a layer of ZnO of thickness in the range 5-50 nanometres, e.g. 11 nanometres, may be provided on a supporting compressible layer of PMMA having a thickness in the range 500-1000 nanometres, e.g. 800 nanometres. With the supporting compressible layer being substantially thicker than the semiconductive layer, relatively high embossing features on the embossing tool may be used to achieve good isolation between the displaced portions of semiconductive material and the undisplaced layer. In certain embodiments the embossing tool may take the form of an embossing shim, and may be held in contact with the device substrate at a temperature of 95°C, for example, for a time of 30 minutes for example.

In certain embodiments, a relatively non-compressible support substrate comprising or consisting of glass may be used to support the compressible layer, which may additionally or alternatively be selected so as to have a low density, such as for a buffer layer of a porous polymer.

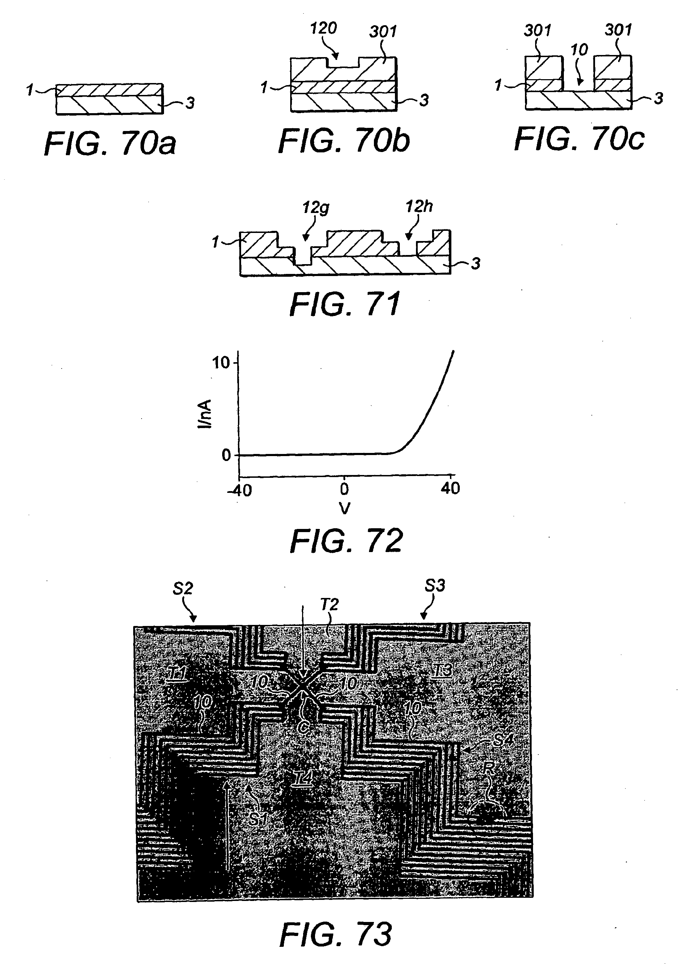

Referring now to Fig. 70, this is a schematic representation of steps in a method for forming an insulative feature in embodiments of the invention. In step (a), a layer of active material 1 is provided, supported on a substrate 3. In step (b) a patterned layer 301 of resist material is provided on top of the active layer 1. This patterned resist layer 301 in certain examples is formed using an embossing technique in which an embossing tool is used to form a pattern of depressions or trenches 120 in the surface of the resist layer 301. It will be appreciated that a wide variety of known techniques may be employed to achieve this. For example, techniques as described in US Patent US 6,284,072 B1 may be employed. Thus, in certain examples, a UV curable relief forming polymer may be supplied and may conform to the patterned surface of an imprint tool arranged above the active layer. The imprint tool or mask may conveniently be transparent to the relevant radiation (UV in certain examples) so that radiation may be applied to the polymer situated between the imprint tool/mask and the active layer so as to cure the polymer. The mask may then be removed, to leave the cured polymer in place over the active layer, with its upper surface appropriately patterned (i.e. embossed, or provided with the appropriate imprint or relief pattern). Thus, Fig. 70(b) shows just one relief feature in the form of a depression or trench 120 formed in the resist layer 301 over the active layer 1. Next, in step (c), an etching process is used to remove imprint material 301. This etching results in the portion of the active layer 1 beneath the depression or recess 120 also being removed, and thinner portions of resist material 301 remaining over the active layer on either side of the etched trench. In this way, an insulative feature 10 is formed in the active layer 1 at a position corresponding to that of the imprinted feature 120 in the surface of the imprint layer 301.

Referring now to Fig. 71, this illustrates the cross sections of further insulative features which may be formed in methods embodying the invention, and which may be incorporated in devices and apparatus embodying the invention. One of these insulative features 12g is a stepped trench formed so as to interrupt the active layer 1 and also extend into the supporting substrate 3. Thus, the width of the trench is not constant over its depth. The trench has a narrower, lower portion which extends into the substrate 3, and a wider, upper portion which opens to the upper surface of the active layer 1. Fig. 71 shows another insulative feature 12h which is also in the form of a stepped trench, but this time the trench terminates at the interface between the active layer 1 and the substrate 3.

Referring now to Fig. 72, this is a graph showing the results of an electrical measurement on an electronic device embodying the invention. The general structure of the device is as shown in Fig. 20, with a plurality of additional insulative features 100 being arranged in parallel to define a plurality of narrow conductive channels, these channels connecting one terminal area of the device to another. In other words, the device is a two terminal device, and functions as a diode. The arrangement of additional insulative features 100 effectively defines a plurality of diodes arranged in parallel. The current-voltage characteristics shown in Fig. 72 is that resulting from the application of a potential across the two terminal areas of the device and exhibits typical diode behaviour as a result of the self-switching nature of the individual diode resulting from the assymetrical arrangement of their insulative features (which define the conductive channels) with respect to the first and second terminal areas. The device whose characteristics are shown in Fig. 72 was formed from an active layer of ZnO of thickness 20 nm on a layer of PBMA of thickness 500 nm, itself supported on a glass substrate. The PBMA layer was spin-coated from anisole (7% wt solution) on the glass. The patterning of the ZnO layer to form the insulative features in it was achieved using a suitably patterned imprint tool. The tool was forced against the ZnO layer to apply pressure of 2000 N/cm² at a temperature of 50°C and held for a period of 30 minutes. After this, the combination of multi-layer substrate structure and tool was cooled to room temperature, and the imprint tool was then removed or separated (in other words, the demold took place at room temperature).

Referring now to Fig. 73, this is a microscopy image of parts of another device useful for understanding the invention. This device is a side-gated transistor, the gate regions being terminals T1 and T3, each corresponding to a respective area of active material, and the source and drain regions being terminal areas T2 and T4. As can be seen on the figure, a plurality of insulative features 10 have been formed in the device to interrupt the active layer to define the transistor channel (of the PNT, i.e. the planar nano transistor) connecting the source and drain regions T2, T4, and to define insulating regions or sectors S1, S2, S3, S4 separating the terminal regions from one another. In this example, each insulating sector S1-S4 generally widens in a stepped manner as one moves further away from the channel of the device, and each insulative sector is subdivided by further insulative features inside its perimeter. The advantage of this arrangement is that even when defects in a single feature or small number of features occur, this does not compromise the electrical isolation between adjacent terminals. Two small defects can be seen in the region inside the ring R. As can be seen, the remaining insulative features of sector S4 maintain electrical isolation between regions T3 and T4. In this particular embodiment the device has been formed by the direct embossing of a layer of ZnO of thickness 20 nm supported on a PMMA substrate of thickness 1 micrometer and ave. molecular weight 495k (supplier: Chestech).. The insulative features were formed using a pulsed-thermal embossing technique (which may also be described as a technique using pulsed voltage heating). Equivalently, this could also be described as a pulsed thermal indentation technique. Essentially the technique involves applying a constant force with instantaneous heating for a given pulse-length (e.g. 50ms). The material immediately beneath and surrounding the tool is progressively displaced by each embossing pulse.

It will be appreciated that whilst the stepped and widening sectors S1-S4 on the device in Fig. 73 are subdivided by arrays of parallel lines, in alternative examples the sectors may be subdivided by different arrangements of insulative features. For example, in certain embodiments, the stepped insulative sectors may be subdivided by grids of insulative features, rectangular or otherwise.

## Claims

1. A method of forming an electrically insulative region from an area of a layer of electrically conductive or semiconductive material, such that electrical current flow within the layer and across said area is at least inhibited, the method comprising:
forming at least one electrically insulative feature in said layer to define an insulative perimeter around said area, the or each insulative feature being arranged to at least inhibit electrical current flow within the layer of material; and
forming at least one further electrically insulative feature inside said perimeter so as to divide said area into a plurality of parts, said parts being at least partially electrically insulated from each another,
wherein said forming of at least one further electrically insulative feature comprises forming a plurality of further electrically insulative features inside said perimeter so as to divide the area into said plurality of parts, and
wherein said plurality of further electrically insulative features comprises a plurality of substantially linear further insulative features arranged as a grid.

2. A method in accordance with claim 1, wherein said plurality of further electrically insulative features comprises a plurality of substantially linear further insulative features arranged in parallel.

3. A method in accordance with any preceding claim, wherein said grid is a rectangular grid.

4. A method in accordance with any preceding claim, wherein said electrically insulative region is arranged to surround a portion of the layer of electrically conductive or semiconductive material, to electrically isolate, at least partly, that portion from a portion outside the electrically insulative region.

5. A method in accordance with any preceding claim, wherein at least one of said insulative and further insulative features comprises a respective trench, groove, or channel formed in said layer so as to interrupt said layer.

6. A method in accordance with any preceding claim, comprising forming each of said insulative and further insulative features at the same time.

7. A method in accordance with any preceding claim, comprising displacing active material at least partially from said layer to form at least one of said insulative and further insulative features.

8. A method in accordance with any preceding claim, comprising using an embossing tool to form at least one of said insulative and further insulative features.

9. A method in accordance with claim 10, wherein said layer is supported by a layer of compressible material, and using the embossing tool comprises urging the embossing tool towards the compressible material so as to displace a plurality of selected portions of the layer of conductive or semiconductive material towards the compressible material so as to compress compressible material under each displaced portion, wherein each displaced portion corresponds to a respective one of the insulative and further insulative features.

10. An electrical or electronic device comprising a layer of electrically active material and at least one electrically insulative region formed from a respective area of said layer using a method in accordance with any preceding claim.

11. A layer of electrically active material interrupted by an electrically insulative region occupying an area of said layer, the electrically insulative region comprising:
at least one electrically insulative feature arranged to interrupt said layer to define an insulative perimeter around said area; and
a plurality of further electrically insulative features arranged inside said perimeter and interrupting said layer so as to divide said area into a plurality of parts, said parts being at least partially electrically insulated from each other, wherein said plurality of further electrically insulative features comprises a plurality of substantially linear further insulative features arranged as a grid.

12. An electrical or electronic device comprising a layer of active material in accordance with claim 11, wherein said electrically insulative region is arranged to isolate a first region of the layer from a second region, and wherein at least one of the first and second regions is patterned to define at least one respective electronic component, e.g. a diode, side-gate (or in-plane gate) transistor, or logic gate.

13. A method of manufacturing an electrical or electronic device comprising a layer of electrically active material, the method comprising using a method in accordance with any one of claims 1 to 9 to form at least one electrically insulative region in said layer.

## Patentansprüche

1. Verfahren zum Bilden einer elektrisch isolierenden Region von einem Bereich einer Schicht aus elektrisch leitendem oder halbleitendem Material, so dass ein elektischer Stromfluss innerhalb der Schicht und durch den Bereich mindestens gehemmt wird, wobei das Verfahren Folgendes umfasst:
Bilden mindestens eines elektrisch isolierenden Merkmals in der Schicht, um einen isolierenden Umfang um den Bereich zu definieren, wobei das oder jedes isolierende Merkmal dafür ausgelegt ist, einen elektrischen Stromfluss innerhalb der Materialschicht mindestens zu hemmen; und
Bilden mindestens eines weiteren elektrisch isolierenden Merkmals innerhalb des Umfangs, um den Bereich in eine Vielzahl von Teilen zu unterteilen, wobei die Teile mindestens teilweise elektrisch voneinander isoliert sind,
wobei das Bilden mindestens eines weiteren, elektrisch isolierenden Merkmals das Bilden einer Vielzahl von weiteren elektrisch isolierenden Merkmalen innerhalb des Umfangs umfasst, so dass der Bereich in die Vielzahl von Teilen unterteilt wird, und
wobei die Vielzahl der weiteren elektrisch isolierenden Merkmale eine Vielzahl von im Wesentlichen linearen weiteren isolierenden Merkmalen umfasst, die in einem Gitter angeordnet sind.

2. Verfahren nach Anspruch 1, wobei die Vielzahl der weiteren elektrisch isolierenden Merkmale eine Vielzahl von im Wesentlichen linearen weiteren isolierenden Merkmalen umfasst, die parallel angeordnet sind.

3. Verfahren nach einem der vorhergehenden Ansprüche, wobei das Gitter ein rechtwinkliges Gitter ist.

4. Verfahren nach einem der vorhergehenden Ansprüche, wobei der elektrisch isolierende Bereich dafür ausgelegt ist, einen Teil der Schicht aus elektrisch leitendem oder halbleitendem Material zu umgeben, um den Abschnitt mindestens teilweise von einem Abschnitt außerhalb der elektrisch isolierenden Region elektrisch zu isolieren.

5. Verfahren nach einem der vorhergehenden Ansprüche, wobei mindestens eines der isolierenden und ferner isolierenden Merkmale einen jeweiligen Graben, eine jeweilige Nut oder einen jeweiligen Kanal umfasst, der bzw. die in der Schicht gebildet ist, um die Schicht zu unterbrechen.

6. Verfahren nach einem der vorhergehenden Ansprüche, das das Bilden jedes der isolierenden und ferner isolierende Merkmale zur gleichen Zeit umfasst.

7. Verfahren nach einem der vorhergehenden Ansprüche, das das Verlagern von aktivem Material mindestens teilweise aus der Schicht umfasst, um mindestens eine der isolierenden und ferner isolierenden Merkmale zu bilden.

8. Verfahren nach einem der vorhergehenden Ansprüche, das das Verwenden eines Prägewerkzeugs zur Bildung des mindestens einen isolierenden und ferner isolierenden Merkmals umfasst.

9. Verfahren nach Anspruch 10, wobei die Schicht von einer Schicht aus komprimierbarem Material gestützt wird und das Verwenden des Prägewerkzeugs das Drücken des Prägewerkzeugs in Richtung des komprimierbaren Materials umfasst, um eine Vielzahl von ausgewählten Abschnitten der Schicht aus leitendem oder halbleitendem Material in Richtung des komprimierbaren Materials zu verlagern, um komprimierbares Material unter jedem verlagerten Abschnitt zu komprimieren, wobei jeder verlagerte Abschnitt einem jeweiligen isolierenden und ferner isolierenden Merkmal entspricht.

10. Elektrische oder elektronische Vorrichtung, die Folgendes umfasst: eine Schicht aus elektrisch aktivem Material und mindestens eine elektrisch isolierende Region, die von einem jeweiligen Bereich der Schicht mit Hilfe eines Verfahrens nach einem der vorhergehenden Ansprüche gebildet ist.

11. Schicht aus einem elektrisch aktiven Material, die durch eine elektrisch isolierende Region unterbrochen ist, die einen Bereich der Schicht besetzt, wobei die elektrisch isolierende Region Folgendes umfasst:
mindestens ein elektrisch isolierendes Merkmal, das dafür ausgelegt ist, die Schicht zu unterbrechen, um einen isolierenden Umfang um den Bereich zu definieren; und
eine Vielzahl von weiteren elektrisch isolierenden Merkmalen, die innerhalb des Umfangs angeordnet sind und die Schicht unterbrechen, um den Bereich in eine Vielzahl von Teilen zu unterteilen, wobei die Teile mindestens teilweise elektrisch voneinander isoliert sind, wobei die Vielzahl der weiteren elektrisch isolierenden Merkmale eine Vielzahl von im Wesentlichen linearen weiteren isolierenden Merkmalen umfasst, die in einem Gitter angeordnet sind.

12. Elektrische oder elektronische Vorrichtung, die eine Schicht aus aktivem Material nach Anspruch 11 umfasst, wobei die elektrisch isolierende Region dafür ausgelegt ist, einen ersten Bereich der Schicht von einem zweiten Bereich zu isolieren, und wobei mindestens eine der ersten und zweiten Regionen so gemustert ist, um mindestens eine entsprechende elektronische Komponente zu definieren, z. B. eine Diode, ein Seitengatter (oder ebenes Gatter), einen Transistor oder ein Logikgatter.

13. Verfahren zur Herstellung einer elektrischen oder elektronischen Vorrichtung, die eine Schicht aus einem elektrisch aktiven Material umfasst, wobei das Verfahren die Verwendung eines Verfahrens nach einem der Ansprüche 1 bis 9 umfasst, um mindestens eine elektrisch isolierende Region in der Schicht zu bilden.

## Revendications

1. Un procédé de formation d'une zone électriquement isolante à partir d'une zone d'une couche de matériau électriquement conducteur ou semiconducteur, de sorte qu'un flux de courant électrique à l'intérieur de la couche et au travers de ladite zone soit au moins inhibé, le procédé comprenant :
la formation d'au moins une caractéristique électriquement isolante dans ladite couche de façon à définir un périmètre isolant autour de ladite zone, la ou chaque caractéristique isolante étant agencée de façon à au moins inhiber un flux de courant électrique à l'intérieur de la couche de matériau, et
la formation d'au moins une autre caractéristique électriquement isolante à l'intérieur dudit périmètre de façon à diviser ladite zone en une pluralité de parties, lesdites parties étant au moins partiellement électriquement isolées les unes des autres,
où ladite formation d'au moins une autre caractéristique électriquement isolante comprend la formation d'une pluralité d'autres caractéristiques électriquement isolantes à l'intérieur dudit périmètre de façon à diviser la zone en ladite pluralité de parties, et
où ladite pluralité d'autres caractéristiques électriquement isolantes comprend une pluralité d'autres caractéristiques isolantes sensiblement linéaires agencées sous la forme d'une grille.

2. Un procédé selon la Revendication 1, où ladite pluralité d'autres caractéristiques électriquement isolantes comprend une pluralité d'autres caractéristiques isolantes sensiblement linéaires agencées en parallèle.

3. Un procédé selon l'une quelconque des Revendications précédentes, où ladite grille est une grille rectangulaire.

4. Un procédé selon l'une quelconque des Revendications précédentes, où ladite zone électriquement isolante est agencée de façon à entourer une partie de la couche de matériau électriquement conducteur ou semiconducteur, de façon à isoler électriquement, au moins partiellement, cette partie d'une partie située à l'extérieur de la zone électriquement isolante.

5. Un procédé selon l'une quelconque des Revendications précédentes, où au moins une desdites caractéristiques isolantes et autres caractéristiques isolantes comprend une tranchée, rainure ou canal respectif formé dans ladite couche de façon à interrompre ladite couche.

6. Un procédé selon l'une quelconque des Revendications précédentes, comprenant la formation de chacune desdites caractéristiques isolantes et autres caractéristiques isolantes simultanément.

7. Un procédé selon l'une quelconque des Revendications précédentes, comprenant le déplacement d'un matériau actif au moins partiellement de ladite couche de façon à former au moins une desdites caractéristiques isolantes et autres caractéristiques isolantes.

8. Un procédé selon l'une quelconque des Revendications précédentes, comprenant l'utilisation d'un outil d'emboutissage de façon à former au moins une desdites caractéristiques isolantes et autres caractéristiques isolantes.

9. Un procédé selon la Revendication 10, où ladite couche est soutenue par une couche de matériau compressible, et l'utilisation de l'outil d'emboutissage comprend la sollicitation de l'outil d'emboutissage vers le matériau compressible de façon à déplacer une pluralité de parties sélectionnées de la couche de matériau conducteur ou semiconducteur vers le matériau compressible de façon à compresser le matériau compressible sous chaque partie déplacée, où chaque partie déplacée correspond à une caractéristique respective des caractéristiques isolantes et autres caractéristiques isolantes.

10. Un dispositif électrique ou électronique comprenant une couche de matériau électriquement actif et au moins une zone électriquement isolante formée à partir d'une zone respective de ladite couche au moyen d'un procédé selon l'une quelconque des Revendications précédentes.

11. Une couche de matériau électriquement actif interrompue par une zone électriquement isolante occupant une zone de ladite couche, la zone électriquement isolante comprenant :
au moins une caractéristique électriquement isolante agencée de façon à interrompre ladite couche de façon à définir un périmètre isolant autour de ladite zone, et
une pluralité d'autres caractéristiques électriquement isolantes agencées à l'intérieur dudit périmètre et interrompant ladite couche de façon à diviser ladite zone en une pluralité de parties, lesdites parties étant au moins partiellement électriquement isolées les unes des autres, où ladite pluralité d'autres caractéristiques électriquement isolantes comprend une pluralité d'autres caractéristiques isolantes sensiblement linéaires agencées sous la forme d'une grille.

12. Un dispositif électrique ou électronique comprenant une couche d'un matériau actif selon la Revendication 11, où ladite zone électriquement isolante est agencée de façon à isoler une première zone de la couche d'une deuxième zone, et où au moins une des première et deuxième zones est conçue de façon à définir au moins un composant électronique respectif, par exemple une diode, un transistor de grille latérale (ou de grille dans le plan) ou une grille logique.

13. Un procédé de fabrication d'un dispositif électrique ou électronique comprenant une couche de matériau électriquement actif, le procédé comprenant l'utilisation d'un procédé selon l'une quelconque des Revendications 1 à 9 destiné à former au moins une zone électriquement isolante dans ladite couche.
